# EUROPEAN PATENT APPLICATION

(11) **EP 4 507 177 A1**
(43) Date of publication of application: **12.02.2025**
(21) Application number: 23831310.0
(22) Date of filing: 23.06.2023
(51) Int. Cl.: H02M 1/08

(54) **SEMICONDUCTOR SWITCH DRIVE CIRCUIT AND POWER CONVERTER**

(30) Priority: 27.06.2022 JP 2022102849
(71) Applicant: IHI Corporation, Tokyo 135-8710 (JP)
(72) Inventor: HISAMOCHI Hirofumi, Tokyo 135-8710 (JP)
(74) Representative: TBK
(86) International application number: PCT/JP2023/023367
(87) International publication number: WO 2024/004868

(57) **Abstract**

A semiconductor switch drive circuit includes a drive power source and a semiconductor switch drive portion. The semiconductor switch drive portion includes a connection switching portion, a capacitor for generating a positive voltage, a capacitor to be charged with electric power, and a capacitor for generating a negative voltage. The connection switching portion alternately switches between a first connection state forming a positive voltage application closed circuit that applies the positive voltage to a gate terminal of the semiconductor switch, and a second connection state forming a negative voltage application closed circuit that applies the negative voltage to the gate terminal of the semiconductor switch. A transfer restricting portion is provided between the drive power source and the semiconductor switch, the transfer restricting portion restricting transfer of electric charge from a path flowing through the positive voltage application closed circuit to another path passing through a positive terminal of the capacitor and not through the gate terminal of the semiconductor switch.

## Description

### Technical Field

The present disclosure relates to a semiconductor switch drive circuit and a power converter.

### Background Art

Patent Literatures 1 to 3 disclose a semiconductor switch drive circuit that drives a semiconductor switch. Such a semiconductor switch drive circuit is used, for example, for a power converter such as an inverter. For example, a normally-off semiconductor switch may be employed as the semiconductor switch. In this case, it is required to supply a negative voltage to the semiconductor switch to reliably control the semiconductor switch to an off state. Patent Literature 1 discloses a configuration in which a drive power source that generates a negative voltage is provided in addition to a drive power source that generates a positive voltage. However, such drive power sources are relatively large and heavy among the components that constitute a semiconductor switch drive circuit. Consequently, these drive power sources may increase the size and weight of a device.

Patent Literature 2 discloses a circuit configuration that is capable of generating both a positive voltage and a negative voltage using a single drive power source. This circuit configuration is provided with a positive power source capacitor that is charged with electric power from the drive power source to generate a positive voltage, and a negative power source capacitor that is charged with electric power from the positive power source capacitor to generate a negative voltage. The positive voltage and the negative voltage are alternately applied to the semiconductor switch. Since the need to separately provide a drive power source that generates a negative voltage is eliminated in this circuit configuration, an increase in the size and weight of a device is suppressed. Patent Literature 3 discloses a circuit configuration provided with a negative power source buffer capacitor that is charged with electric power for generating a negative voltage in addition to the circuit configuration disclosed in Patent Literature 2. In this circuit configuration, the negative power source capacitor is charged via the negative power source buffer capacitor without being directly charged by the positive power source capacitor.

### Citation List

### Patent Literature

[Patent Literature 1] Japanese Unexamined Patent Publication No. H8-186976
[Patent Literature 2] Japanese Unexamined Patent Publication No. 2018-33303
[Patent Literature 3] Japanese Unexamined Patent Publication No. 2019-75887

### Summary of Invention

### Technical Problem

In the semiconductor switch drive circuit disclosed in Patent Literature 3, the transfer path of electric charge that flows through the positive power source capacitor and the semiconductor switch during the application of the positive voltage to the semiconductor switch is a path that does not pass through a third capacitor. In this case, the positive voltage of the positive power source capacitor is prevented from being divided between the semiconductor switch and the negative power source capacitor during the application of the positive voltage to the semiconductor switch. This suppresses a reduction in the positive voltage of the positive power source capacitor. However, there may still be factors causing the reduction in the positive voltage of the positive power source capacitor in the semiconductor switch drive circuit other than the voltage division by the negative power source capacitor. There is thus room for improvement from the perspective of suppressing the reduction in the positive voltage to the semiconductor switch.

The present disclosure describes a semiconductor switch drive circuit and a power converter which are capable of effectively suppressing a reduction in the positive voltage to a semiconductor switch.

### Solution to Problem

A semiconductor switch drive circuit according to an embodiment of the present disclosure includes a drive power source, and a semiconductor switch drive portion electrically connected to the drive power source, and configured to drive a semiconductor switch using electric power from the drive power source. The semiconductor switch drive portion includes: a connection switching portion electrically connected between the drive power source and the semiconductor switch, and configured to switch a connection state of the semiconductor switch; a first capacitor electrically connected between the drive power source and the connection switching portion, and configured to generate a positive voltage for turning the semiconductor switch to an on state by being charged with the electric power from the drive power source; a second capacitor electrically connected in parallel with the first capacitor with respect to the drive power source, and configured to be charged with the electric power from the drive power source; and a third capacitor electrically connected between the second capacitor and the connection switching portion, and configured to generate a negative voltage for turning the semiconductor switch to an off state by being charged with electric power discharged from the second capacitor in a charged state. The connection switching portion is configured to alternately switch between a first connection state forming a positive voltage application closed circuit configured to apply the positive voltage to a control terminal of the semiconductor switch by an electrical connection between a positive terminal of the first capacitor and the control terminal of the semiconductor switch, and a second connection state forming a negative voltage application closed circuit configured to apply the negative voltage to the control terminal of the semiconductor switch by an electrical connection between a negative terminal of the third capacitor and the control terminal of the semiconductor switch. A transfer restricting portion is provided between the first capacitor and the semiconductor switch, the transfer restricting portion configured to restrict transfer of electric charge of the first capacitor from a path passing through the positive voltage application closed circuit to another path passing through the positive terminal of the first capacitor and not through the control terminal of the semiconductor switch.

### Effects of Invention

The present disclosure provides a semiconductor switch drive circuit and a power converter which are capable of effectively suppressing a reduction in the positive voltage to a semiconductor switch.

### Brief Description of Drawings

FIG. 1 is a circuit diagram illustrating a power converter according to a first embodiment.
FIG. 2 is a diagram describing an operation of a semiconductor switch drive circuit of the power converter of FIG. 1.
FIG. 3 is a diagram describing an operation of the semiconductor switch drive circuit of the power converter of FIG. 1.
FIG. 4 is a diagram describing an operation of the semiconductor switch drive circuit of the power converter of FIG. 1.
FIG. 5 is a diagram describing an operation of the semiconductor switch drive circuit of the power converter of FIG. 1.
FIG. 6 is a circuit diagram illustrating a variation of the power converter of FIG. 1.
FIG. 7 is a circuit diagram illustrating a power converter according to a second embodiment.
FIG. 8 is a diagram describing an operation of a semiconductor switch drive circuit of the power converter of FIG. 7.
FIG. 9 is a diagram describing an operation of the semiconductor switch drive circuit of the power converter of FIG. 7.
FIG. 10 is a diagram describing an operation of the semiconductor switch drive circuit of the power converter of FIG. 7.
FIG. 11 is a diagram describing an operation of the semiconductor switch drive circuit of the power converter of FIG. 7.
FIG. 12 is a diagram describing the problem of a power converter according to a comparative example.

### Description of Embodiments

Embodiments of the present disclosure will be described below with reference to the drawings. Same reference signs are given to the same elements in the description of the drawings, and redundant description will be omitted.

A semiconductor switch drive circuit according to an embodiment of the present disclosure includes a drive power source, and a semiconductor switch drive portion electrically connected to the drive power source, and configured to drive a semiconductor switch using electric power from the drive power source. The semiconductor switch drive portion includes: a connection switching portion electrically connected between the drive power source and the semiconductor switch, and configured to switch a connection state of the semiconductor switch; a first capacitor electrically connected between the drive power source and the connection switching portion, and configured to generate a positive voltage for turning the semiconductor switch to an on state by being charged with the electric power from the drive power source; a second capacitor electrically connected in parallel with the first capacitor with respect to the drive power source, and configured to be charged with the electric power from the drive power source; and a third capacitor electrically connected between the second capacitor and the connection switching portion, and configured to generate a negative voltage for turning the semiconductor switch to an off state by being charged with electric power discharged from the second capacitor in a charged state. The connection switching portion is configured to alternately switch between a first connection state forming a positive voltage application closed circuit configured to apply the positive voltage to a control terminal of the semiconductor switch by an electrical connection between a positive terminal of the first capacitor and the control terminal of the semiconductor switch, and a second connection state forming a negative voltage application closed circuit configured to apply the negative voltage to the control terminal of the semiconductor switch by an electrical connection between a negative terminal of the third capacitor and the control terminal of the semiconductor switch. A transfer restricting portion is provided between the first capacitor and the semiconductor switch, the transfer restricting portion configured to restrict transfer of electric charge of the first capacitor from a path passing through the positive voltage application closed circuit to another path passing through the positive terminal of the first capacitor and not through the control terminal of the semiconductor switch.

In the semiconductor switch drive circuit above, a positive voltage is generated in the first capacitor by the electric power from the drive power source, and a negative voltage is generated in the third capacitor by the electric power discharged from the second capacitor in a charged state. That is, the positive voltage and the negative voltage are generated using a single drive power source. Additionally, the semiconductor switch is alternately switched on or off by the connection switching portion alternately switching between the first connection state that forms the positive voltage application closed circuit in which the positive voltage of the first capacitor is applied to the control terminal of the semiconductor switch, and a second connection state that forms the negative voltage application closed circuit in which the negative voltage of the third capacitor is applied to the control terminal of the semiconductor switch. The semiconductor switch drive circuit above is provided with the second capacitor for charging the third capacitor. This eliminates the need to arrange the third capacitor in the positive voltage application closed circuit, in which the positive voltage of the first capacitor is applied to the control terminal of the semiconductor switch, to charge the third capacitor. This prevents the positive voltage of the first capacitor from being divided between the semiconductor switch and the third capacitor. Furthermore, the semiconductor switch drive circuit above is provided with the transfer restricting portion that restricts transfer of the charge of the first capacitor from a path passing through the positive voltage application closed circuit to another path passing through the positive terminal of the first capacitor and not through the control terminal of the semiconductor switch. This makes it possible to prevent the positive voltage of the first capacitor from being divided between circuit elements in the path passing through the positive voltage application closed circuit and the other path. Consequently, in the semiconductor switch drive circuit above, it is possible to effectively suppress a reduction in the positive voltage from the first capacitor to the semiconductor switch.

In some aspects, the transfer restricting portion may include: a first connection point between the positive terminal of the first capacitor and the control terminal of the semiconductor switch; a second connection point between a positive terminal of the second capacitor and an input terminal of the semiconductor switch; a third connection point arranged between the first connection point and a positive terminal of the drive power source, and electrically connected to the positive terminal of the drive power source; a first wire connecting the first connection point and the third connection point; and a second wire connecting the second connection point and the third connection point. In the case in which the third connection point is provided between the first connection point and the drive power source in this way, it is possible to prevent the charge released from the first capacitor from being transferred to the second connection point through the first connection point and the third connection point, while allowing the charge to be transferred from the drive power source to the first capacitor through the third connection point and the first connection point. This makes it possible to prevent the charge of the first capacitor transferred through the positive voltage application closed circuit from being transferred to another path from the first connection point through the second connection point. As a result, it is possible to more efficiently suppress the reduction in the positive voltage from the first capacitor to the semiconductor switch.

In some aspects, the transfer restricting portion may further include a first diode connected with a direction from the third connection point toward the first connection point as a forward direction in the first wire, and a second diode connected with a direction from the third connection point toward the second connection point as a forward direction in the second wire. Having the first diode and the second diode provided in this way prevents backflow of the charge from the first capacitor and the second capacitor to the drive power source. Furthermore, having the first diode provided between the third connection point and the first connection point prevents the charge of the first capacitor from being transferred from the first connection point to the second connection point through the third connection point. This makes it possible to more effectively suppress the reduction in the positive voltage from the first capacitor to the semiconductor switch since transfer of the charge of the first capacitor to another path through the second connection point is prevented.

In some aspects, the transfer restricting portion may further include a first resistive element connected in series with the first diode in the first wire, and a second resistive element connected in series with the second diode in the second wire, and having a resistance value higher than a resistance value of the first resistive element. The negative voltage for turning the semiconductor switch to an off state tends to be smaller than the positive voltage for turning the semiconductor switch to an on state. In the case in which the negative voltage is smaller in this way, the amount of charge of the second capacitor storing the electric power for generating a negative voltage may be less than the amount of charge of the first capacitor storing the electric power for generating a positive voltage. Thus, in the configuration described above, the second resistive element provided in the transfer path of the charge flowing from the drive power source to the second capacitor has a resistance value higher than the resistance value of the first resistive element provided in the transfer path of the charge flowing from the drive power source to the first capacitor. This makes it possible to minimize the charging current supplied from the drive power source to the second capacitor. As a result, it is possible to suppress an increase in the capacity of the drive power source that provides the second capacitor with electric power.

In some aspects, the positive terminal of the first capacitor may be electrically connected to a positive terminal of the drive power source and the control terminal of the semiconductor switch. A positive terminal of the second capacitor may be electrically connected to the positive terminal of the drive power source. The negative terminal of the third capacitor may be electrically connected to a negative terminal of the second capacitor. A positive terminal of the third capacitor may be electrically connected to the control terminal of the semiconductor switch. In this case, the configuration for generating the positive voltage and the negative voltage using a single drive power source can be easily achieved.

In some aspects, the semiconductor switch drive circuit may include a first semiconductor switch drive portion and a second semiconductor switch drive portion being the semiconductor switch drive portion. The first semiconductor switch drive portion and the second semiconductor switch drive portion may be configured to respectively drive a first semiconductor switch and a second semiconductor switch being the semiconductor switch. The first semiconductor switch may form an upper arm in the semiconductor switch drive circuit. The second semiconductor switch may form a lower arm in the semiconductor switch drive circuit, and may be electrically connected in series with the first semiconductor switch. In this case, the reduction in the positive voltage from the first capacitor to the semiconductor switch can be effectively suppressed in both the upper arm and the lower arm.

In some aspects, the transfer restricting portion of each of the first semiconductor switch drive portion and the second semiconductor switch drive portion may include: a first connection point between the positive terminal of the first capacitor and the control terminal of the semiconductor switch; a second connection point between a positive terminal of the second capacitor and an input terminal of the semiconductor switch; a third connection point arranged between the first connection point and a positive terminal of the drive power source, and electrically connected to the positive terminal of the drive power source; a first wire connecting the first connection point and the third connection point; and a second wire connecting the second connection point and the third connection point. Only the transfer restricting portion of the second semiconductor switch drive portion among the first semiconductor switch drive portion and the second semiconductor switch drive portion may further include a first diode connected with a direction from the third connection point toward the first connection point as a forward direction in the first wire, and a second diode connected with a direction from the third connection point toward the second connection point as a forward direction in the second wire. In the upper arm, backflow of the charge to the drive power source tends to occur due to the circuit configuration according to whether the semiconductor switch is on or off. In the lower arm, however, backflow of the charge to the drive power source tends not to occur regardless of whether the semiconductor switch is on or off. Thus, in the configuration described above, the first diode and the second diode for preventing backflow are provided only in the first semiconductor switch drive portion that forms the upper arm. This simplifies the circuit configuration of the second semiconductor switch drive portion, and makes it possible to reduce the number of components that form the second semiconductor switch drive portion.

In some aspects, the semiconductor switch drive circuit may include a first semiconductor switch drive portion being the semiconductor switch drive portion, and configured to drive a first semiconductor switch being the semiconductor switch, and a second semiconductor switch drive portion electrically connected to the drive power source, and configured to drive a second semiconductor switch electrically connected in series with the first semiconductor switch using the electric power from the drive power source. The first semiconductor switch may form an upper arm in the semiconductor switch drive circuit. The second semiconductor switch may form a lower arm in the semiconductor switch drive circuit. The second semiconductor switch drive portion may include: another connection switching portion electrically connected between the drive power source and the second semiconductor switch, and configured to switch a connection state of the second semiconductor switch; a fourth capacitor electrically connected between the drive power source and the other connection switching portion, and configured to generate a positive voltage for turning the second semiconductor switch to an on state by being charged with the electric power from the drive power source; and a fifth capacitor electrically connected in series between the fourth capacitor and the other connection switching portion, and configured to generate a negative voltage for turning the second semiconductor switch to an off state by being charged with electric power discharged from the fourth capacitor in a charged state. The other connection switching portion may be configured to alternately switch between a third connection state forming another positive voltage application closed circuit configured to apply the positive voltage to a control terminal of the second semiconductor switch by an electrical connection between a positive terminal of the fourth capacitor and the control terminal of the second semiconductor switch, and a fourth connection state forming another negative voltage application closed circuit configured to apply the negative voltage to the control terminal of the second semiconductor switch by an electrical connection between a negative terminal of the fifth capacitor and the control terminal of the second semiconductor switch. In the upper arm, the charge state of the first capacitor is switched according to whether the semiconductor switch is on or off, so that the voltage of the first capacitor tends to vary. In the lower arm, however, the fourth capacitor can be kept charged at all times, so that it is easy to maintain the voltage of the fourth capacitor constant. Thus, the lower arm employs a simplified circuit configuration in which no configurations corresponding to the second capacitor of the upper arm are provided, so that the number of components that form the second semiconductor switch drive portion can be reduced.

A power converter according to an embodiment of the present disclosure converts an aspect of electric power provided by a power source into an aspect of electric power required by a load device. This power converter includes the semiconductor switch electrically connected between the power source and the load device, and any one of the semiconductor switch drive circuits described above electrically connected to the semiconductor switch, and configured to drive the semiconductor switch. This power converter includes any one of the semiconductor switch drive circuits described above, so that it is possible to more effectively suppress the reduction in the positive voltage from the first capacitor to the semiconductor switch.

### [First Embodiment]

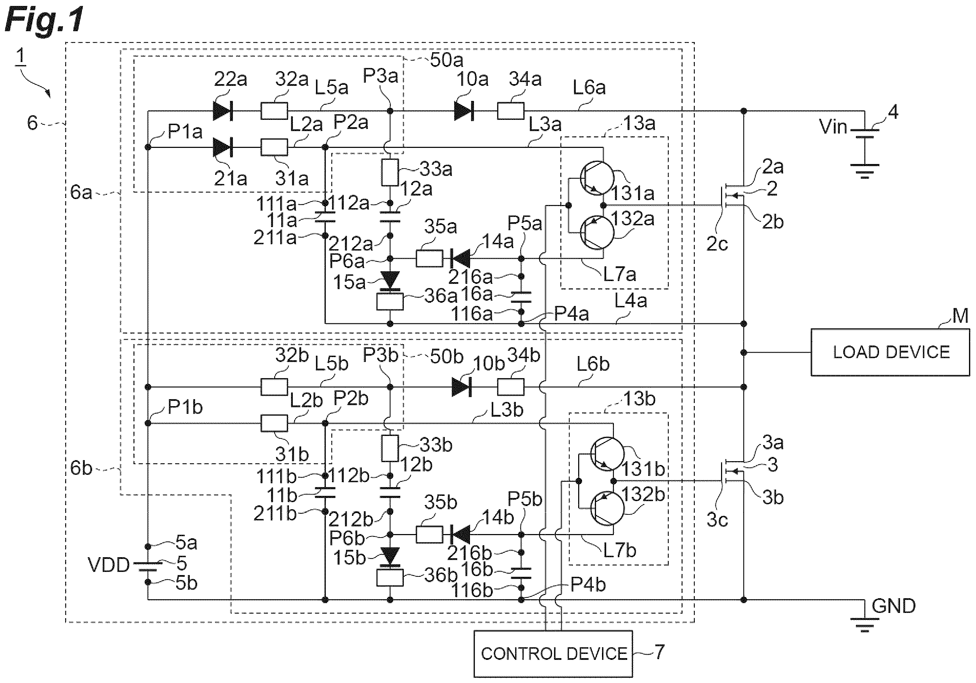

A power converter 1 according a first embodiment will be described with reference to FIG. 1. The power converter 1 converts an aspect of electric power received from a power source 4 into an aspect of electric power required by a load device M. The power source 4 is a power source for driving the load device M. The load device M may be, for example, a three-phase alternating current motor used as a drive source for rotating an impeller. Consequently, the power converter 1 may be employed as an electric component of an electric compressor or an electric blower. The power converter 1 according to this embodiment is, for example, an inverter that converts direct current (DC) power into alternating current (AC) power. The power converter 1 may be a converter that converts AC power into DC power. The power converter 1 may convert DC power of a first aspect into DC power of a second aspect.

As illustrated in FIG. 1, the power converter 1 includes, for example, a semiconductor switch 2 (an example of "first semiconductor switch"), a semiconductor switch 3 (an example of "second semiconductor switch"), a semiconductor switch drive circuit 6, the power source 4, and a control device 7.

The semiconductor switch 2 and the semiconductor switch 3 are connected in series between the power source 4 and ground (GND), and form a switching leg. The semiconductor switch 2 forms a so-called upper arm in the semiconductor switch drive circuit 6. The semiconductor switch 3 forms a so-called lower arm in the semiconductor switch drive circuit 6. Each of the semiconductor switch 2 and the semiconductor switch 3 is, for example, an n-type metal-oxide-semiconductor field-effect transistor (MOSFET). Each of the semiconductor switch 2 and the semiconductor switch 3 may be an insulated gate bipolar transistor (IGBT), or a switch for a wide gap semiconductor such as silicon carbide (SiC) or gallium nitride (GaN).

A drain terminal 2a (an example of "input terminal") of the semiconductor switch 2 is connected to the power source 4. A source terminal 2b (an example of "output terminal") of the semiconductor switch 2 is connected to a drain terminal 3a (an example of "input terminal") of the semiconductor switch 3. A source terminal 3b (an example of "output terminal") of the semiconductor switch 3 is connected to GND. A gate terminal 2c (an example of "control terminal") of the semiconductor switch 2 and a gate terminal 3c (an example of "control terminal") of the semiconductor switch 3 are connected to the semiconductor switch drive circuit 6.

In the description below, an element being "connected" to another element refers to an element being "electrically connected" to another element, unless otherwise specified. "Electrically connected" means that two elements are connected such that signals can be transmitted and electric power can be supplied between the two elements. Consequently, "electrically connected" includes both a case in which two elements are directly connected by a wire, and a case in which two elements are indirectly connected via other electric elements.

The semiconductor switch drive circuit 6 drives the semiconductor switch 2 and the semiconductor switch 3. The control device 7 is electrically connected to the semiconductor switch drive circuit 6, and controls the semiconductor switch drive circuit 6. The control device 7 is composed of a computer including, for example, a CPU, a ROM, and a RAM. The control device 7 controls the semiconductor switch drive circuit 6 such that the semiconductor switch 2 and the semiconductor switch 3 are alternately in an on state. Thus, an input voltage Vin provided from the power source 4 is converted into an AC voltage and supplied to the load device M.

The semiconductor switch drive circuit 6 includes, for example, a semiconductor switch drive portion 6a (an example of "first semiconductor switch drive circuit"), a semiconductor switch drive portion 6b (an example of "second semiconductor switch drive circuit"), and a drive power source 5.

The semiconductor switch drive portion 6a is an upper arm drive circuit that drives the semiconductor switch 2. The semiconductor switch drive portion 6b is a lower arm drive circuit that drives the semiconductor switch 3. The drive power source 5 is, for example, a DC power source that outputs a DC voltage VDD which has a positive polarity. The drive power source 5 is electrically connected to the semiconductor switch drive portion 6a and the semiconductor switch drive portion 6b, and provides the semiconductor switch drive portion 6a and the semiconductor switch drive portion 6b with the voltage VDD. The semiconductor switch drive portion 6a switches the semiconductor switch 2 on or off using the voltage VDD. The semiconductor switch drive portion 6b switches the semiconductor switch 3 on or off using the voltage VDD.

The control device 7 is electrically connected to the semiconductor switch drive portion 6a and the semiconductor switch drive portion 6b. The control device 7 outputs a control signal for controlling driving of the semiconductor switch drive portion 6a and the semiconductor switch drive portion 6b to each of the semiconductor switch drive portion 6a and the semiconductor switch drive portion 6b. The control signal is, for example, a pulse width modulation (PWM) signal. The control device 7 controls the switching on or off of the semiconductor switch 2 by outputting a control signal instructing an on or off state of the semiconductor switch 2 to the semiconductor switch drive portion 6a. Upon receiving a control signal instructing the on state of the semiconductor switch 2, the semiconductor switch drive portion 6a generates a positive voltage for sufficiently turning on the semiconductor switch 2 using the voltage VDD, and applies the generated positive voltage to the gate terminal 2c of the semiconductor switch 2. The semiconductor switch 2 is thus in the on state. Upon receiving a control signal instructing the off state of the semiconductor switch 2, the semiconductor switch drive portion 6a generates a negative voltage for sufficiently turning off the semiconductor switch 2 using the voltage VDD, and applies the generated negative voltage to the gate terminal 2c of the semiconductor switch 2. The semiconductor switch 2 is thus in the off state.

The control device 7 controls the switching on or off of the semiconductor switch 3 by outputting a control signal instructing the on or off state of the semiconductor switch 3 to the semiconductor switch drive portion 6b. Upon receiving a control signal instructing the on state of the semiconductor switch 3, the semiconductor switch drive portion 6b generates a positive voltage for sufficiently turning on the semiconductor switch 3 using the voltage VDD, and applies the generated positive voltage to the gate terminal 3c of the semiconductor switch 3. The semiconductor switch 3 is thus in the on state. Upon receiving a control signal instructing the off state of the semiconductor switch 3, the semiconductor switch drive portion 6b generates a negative voltage for sufficiently turning off the semiconductor switch 3 using the voltage VDD, and applies the generated negative voltage to the gate terminal 3c of the semiconductor switch 3. The semiconductor switch 3 is thus in the off state.

The configurations of the semiconductor switch drive portion 6a and the semiconductor switch drive portion 6b will be described more specifically below.

The semiconductor switch drive portion 6a includes, for example, a connection switching portion 13a, a capacitor 11a (an example of "first capacitor"), a capacitor 12a (an example of "second capacitor"), a capacitor 16a (an example of "third capacitor"), a diode 21a, a diode 22a, a diode 10a, a diode 14a, a diode 15a, a resistive element 31a, a resistive element 32a, a resistive element 33a, a resistive element 34a, a resistive element 35a, and a resistive element 36a.

The connection switching portion 13a is connected between the drive power source 5 and the semiconductor switch 2. The capacitor 11a is connected between the drive power source 5 and the connection switching portion 13a. The capacitor 11a is, for example, a positive power source capacitor that generates a positive voltage. A positive terminal 111a (one end) of the capacitor 11a is connected to a positive terminal 5a of the drive power source 5 and the connection switching portion 13a. More specifically, the positive terminal 5a of the drive power source 5 is connected to a wire L2a at a connection point P1a, and the wire L2a is connected to the positive terminal 111a of the capacitor 11a at a connection point P2a. The wire L2a is connected to a wire L3a at the connection point P2a, and the wire L3a is connected to the gate terminal 2c of the semiconductor switch 2 via the connection switching portion 13a. A negative terminal 211a (the other end) of the capacitor 11a is connected to the source terminal 2b of the semiconductor switch 2 via a wire L4a.

The capacitor 12a is, for example, a negative power source buffer capacitor that is temporarily charged with the electric power for generating a negative voltage. The capacitor 12a is connected between the drive power source 5 and the semiconductor switch 2. The capacitor 12a is connected in parallel with the capacitor 11a with respect to the drive power source 5. A positive terminal 112a (one end) of the capacitor 12a is connected to the positive terminal 5a of the drive power source 5 and the drain terminal 2a of the semiconductor switch 2. More specifically, the positive terminal 5a of the drive power source 5 is connected to a wire L5a extending in parallel with the wire L2a at the connection point P1a. The wire L5a is connected to the positive terminal 112a of the capacitor 12a at a connection point P3a. The wire L5a is connected to a wire L6a at the connection point P3a, and the wire L6a is connected to the drain terminal 2a of the semiconductor switch 2. A negative terminal 212a (the other end) of the capacitor 12a is connected to the drain terminal 2a of the semiconductor switch 2 via the wire L4a.

The capacitor 16a is, for example, a negative power source capacitor that generates a negative voltage by receiving electric power from the capacitor 12a in a charged state. The capacitor 16a is connected between the capacitor 12a and the connection switching portion 13a. A negative terminal 216a (other end) of the capacitor 16a is connected to a wire L7a at a connection point P5a, and the wire L7a is connected to the negative terminal 212a of the capacitor 12a via a connection point P6a. A positive terminal 116a (one end) of the capacitor 16a is connected to the wire L4a at a connection point P4a, and connected to the source terminal 2b of the semiconductor switch 2 via the wire L4a.

The diode 21a is connected in series between the drive power source 5 and the capacitor 11a. The diode 21a is, for example, a backflow prevention diode. The diode 21a is connected with a direction from the connection point P1a toward the connection point P2a as a forward direction in the wire L2a connecting the connection point P1a connected to the positive terminal 5a of the drive power source 5 and the connection point P2a connected to the positive terminal 111a of the capacitor 11a. Thus, an anode of the diode 21a is connected to the positive terminal 5a of the drive power source 5, and a cathode of the diode 21a is connected to the positive terminal 111a of the capacitor 11a.

The resistive element 31a is, for example, a limiting resistance that limits the electric current from the drive power source 5 to the capacitor 11a. The resistive element 31a is connected in series between the diode 21a and the capacitor 11a. More specifically, the resistive element 31a is connected in series between the diode 21a and the connection point P2a in the wire L2a. One end of the resistive element 31a is connected to the positive terminal 5a of the drive power source 5 via the diode 21a. The other end of the resistive element 31a is connected to the positive terminal 111a of the capacitor 11a.

The diode 22a is connected in series between the drive power source 5 and the capacitor 12a. The diode 22a is, for example, a backflow prevention diode. The diode 22a is connected with a direction from the connection point P1a toward the connection point P3a as a forward direction in the wire L3a connecting the connection point P1a and the connection point P3a connected to the positive terminal 112a of the capacitor 12a. Thus, an anode of the diode 22a is connected to the positive terminal 5a of the drive power source 5. A cathode of the diode 22a is connected to the positive terminal 112a of the capacitor 12a.

The resistive element 32a is, for example, a limiting resistance that limits the electric current from the drive power source 5 to the capacitor 12a. The resistive element 32a is connected in series between the diode 22a and the capacitor 12a. More specifically, the resistive element 32a is connected in series between the diode 22a and the connection point P3a in the wire L3a. One end of the resistive element 32a is connected to the positive terminal 5a of the drive power source 5 via the diode 22a. The other end of the resistive element 32a is connected to the positive terminal 112a of the capacitor 12a. The resistive element 32a, for example, has a resistance value that is different from a resistance value of the resistive element 31a. The resistance value of the resistive element 32a may be higher than the resistance value of the resistive element 31a.

The resistive element 33a is connected in series between the positive terminal 112a of the capacitor 12a and the connection point P3a. The resistive element 33a is a limiting resistance that limits the electric current from the drive power source 5 to the capacitor 12a, and the electric current from the capacitor 12a to the capacitor 16a. One end of the resistive element 33a is connected to the positive terminal 5a of the drive power source 5 via the resistive element 32a and the diode 22a. One end of the resistive element 33a is connected to the positive terminal 116a of the capacitor 16a via the semiconductor switch 2. The other end of the resistive element 33a is connected to the positive terminal 112a of the capacitor 12a.

The diode 10a is connected in series between the connection point P3a and the drain terminal 2a of the semiconductor switch 2. The diode 10a is, for example, a backflow prevention diode. The diode 10a is connected with a direction from the connection point P3a toward the drain terminal 2a of the semiconductor switch 2 as a forward direction in the wire L6a between the connection point P3a and the drain terminal 2a. As a result, the diode 10a is connected in series with the diode 22a and the resistive element 32a. The diode 10a is connected in series with the semiconductor switch 2 and the capacitor 16a. Thus, an anode of the diode 10a is connected to the positive terminal 5a of the drive power source 5 via the diode 22a and the resistive element 32a. A cathode of the diode 10a is connected to the positive terminal 116a of the capacitor 16a via the semiconductor switch 2.

The resistive element 34a is connected in series between the diode 10a and the drain terminal 2a of the semiconductor switch 2. The resistive element 34a is, for example, a limiting resistance that limits the electric current from the capacitor 12a to the capacitor 16a. One end of the resistive element 34a is connected to the positive terminal 5a of the drive power source 5 via the diode 10a, the resistive element 32a, and the diode 22a. The other end of the resistive element 34a is connected to the positive terminal 116a of the capacitor 16a via the semiconductor switch 2.

The diode 14a is connected in series between the connection point P5a and the connection point P6a. The diode 14a is, for example, a rectifying diode. The diode 14a is connected with a direction from the connection point P5a toward the connection point P6a as a forward direction in the wire L7a between the connection point P5a and the connection point P6a. An anode of the diode 14a is connected to the connection switching portion 13a and the negative terminal 216a of the capacitor 16a via the connection point P5a. A cathode of the diode 14a is connected to the negative terminal 212a of the capacitor 12a via the connection point P6a.

The resistive element 35a is connected in series between the diode 14a and the connection point P6a. The resistive element 35a is, for example, a limiting resistance that limits the electric current from the capacitor 12a to the capacitor 16a. One end of the resistive element 35a is connected to the negative terminal 212a of the capacitor 12a via the connection point P6a. The other end of the resistive element 35a is connected to the negative terminal 216a of the capacitor 16a via the diode 14a and the connection point P5a.

The diode 15a is connected in series between the connection point P6a and the wire L4a, and in parallel with the capacitor 16a. The diode 15a is connected with a direction from the connection point P6a toward the wire L4a as a forward direction. The diode 15a is, for example, a voltage limiting diode that limits the voltage across the capacitor 16a to a predetermined voltage. The predetermined voltage is, for example, a negative voltage applied to the gate terminal 2c of the semiconductor switch 2 as a gate voltage. This voltage is set based, for example, on a withstand voltage of the gate terminal 2c of the semiconductor switch 2.

The resistive element 36a is connected in series between the diode 10a and the wire L4a. The resistive element 36a is, for example, a limiting resistance that limits the electric current from the drive power source 5 to the capacitor 12a. One end of the resistive element 36a is connected to the negative terminal 211a of the capacitor 12a via the diode 15a. The other end of the resistive element 36a is connected to the wire L4a.

The connection switching portion 13a includes a switch 131a and a switch 132a connected in series with each other. For example, the switch 131a is an NPN-type IGBT, and the switch 132a is a PNP-type IGBT. The switch 131a and the switch 132a form a so-called push-pull circuit. A collector terminal of the switch 131a is connected to the positive terminal 111a of the capacitor 11a. An emitter terminal of the switch 131a is connected to an emitter terminal of the switch 132a. A connection point between the emitter terminal of the switch 131a and the emitter terminal of the switch 132a is connected to the gate terminal 2c of the semiconductor switch 2. A collector terminal of the switch 132a is connected to the negative terminal 216a of the capacitor 16a. A base terminal of the switch 131a and a base terminal of the switch 132a are connected to the control device 7, and receive a control signal from the control device 7.

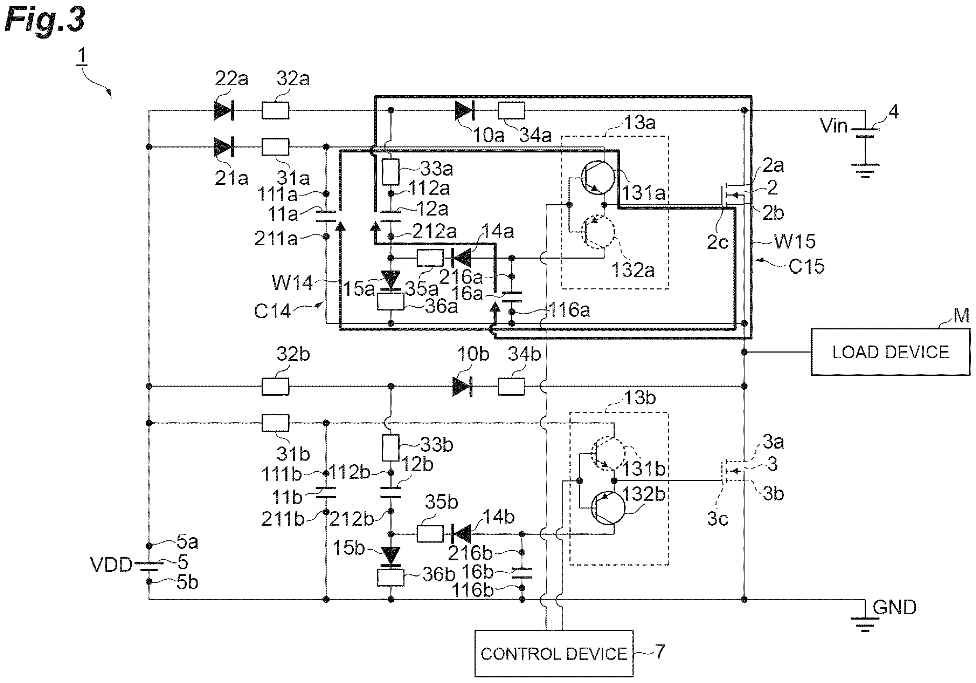

Upon receiving a control signal instructing the on state of the semiconductor switch 2, the connection switching portion 13a is controlled to a first connection state in which the switch 131a is in an on state and the switch 132a is in an off state. In the first connection state, a positive voltage application closed circuit C14 that applies a positive voltage of the capacitor 11a to the gate terminal 2c of the semiconductor switch 2 and a negative voltage charging closed circuit C15 that charges the capacitor 16a with a negative voltage are formed (see FIG. 3).

The positive voltage application closed circuit C14 is a closed circuit that passes a path W14 in FIG. 3. The positive voltage application closed circuit C14 is formed by the positive terminal 111a of the capacitor 11a being connected to the gate terminal 2c of the semiconductor switch 2 via the switch 131a in the on state. The positive voltage application closed circuit C14 includes, for example, the capacitor 11a, the switch 131a, and the semiconductor switch 2. In the positive voltage application closed circuit C14, the charge stored in the capacitor 11a is supplied to the semiconductor switch 2 through the switch 131a. Thus, an input capacitance of the semiconductor switch 2 begins to be charged with the charge discharged from the capacitor 11a. Subsequently, the semiconductor switch 2 is turned to the on state by a certain amount of charge being stored in the input capacitance of the semiconductor switch 2. In this embodiment, no resistive elements are included in the positive voltage application closed circuit C14.

The negative voltage charging closed circuit C15 is a closed circuit that passes a path W15 in FIG. 3. The negative voltage charging closed circuit C15 is formed by the positive terminal 112a of the capacitor 12a being connected to the positive terminal 116a of the capacitor 16a via the switch 131a in the on state. The negative voltage charging closed circuit C15 includes, for example, the capacitor 12a, the resistive element 33a, the diode 10a, the resistive element 34a, the semiconductor switch 2, the capacitor 16a, the diode 14a, and the resistive element 35a. In the negative voltage charging closed circuit C15, the charge stored in the capacitor 12a is supplied to the capacitor 16a through the resistive element 33a, the diode 10a, the resistive element 34a, and the semiconductor switch 2. The capacitor 16a is charged with this charge from the capacitor 12a. When this happens, the positive terminal 116a of the capacitor 16a is charged with a positive charge, and the negative terminal 216a of the capacitor 16a is charged with a negative charge. A negative voltage is thus generated in the capacitor 16a.

In the negative voltage charging closed circuit C15, the charge stored in the capacitor 12a flows so as to pass through the resistive element 33a, the resistive element 34a, and the resistive element 35a. Thus, the resistive element 33a, the resistive element 34a, and the resistive element 35a have the function of limiting the charging current from the capacitor 12a to the capacitor 16a. Consequently, the charging current to the capacitor 16a can be adjusted by adjusting the combined resistance value of the resistive element 33a, the resistive element 34a, and the resistive element 35a.

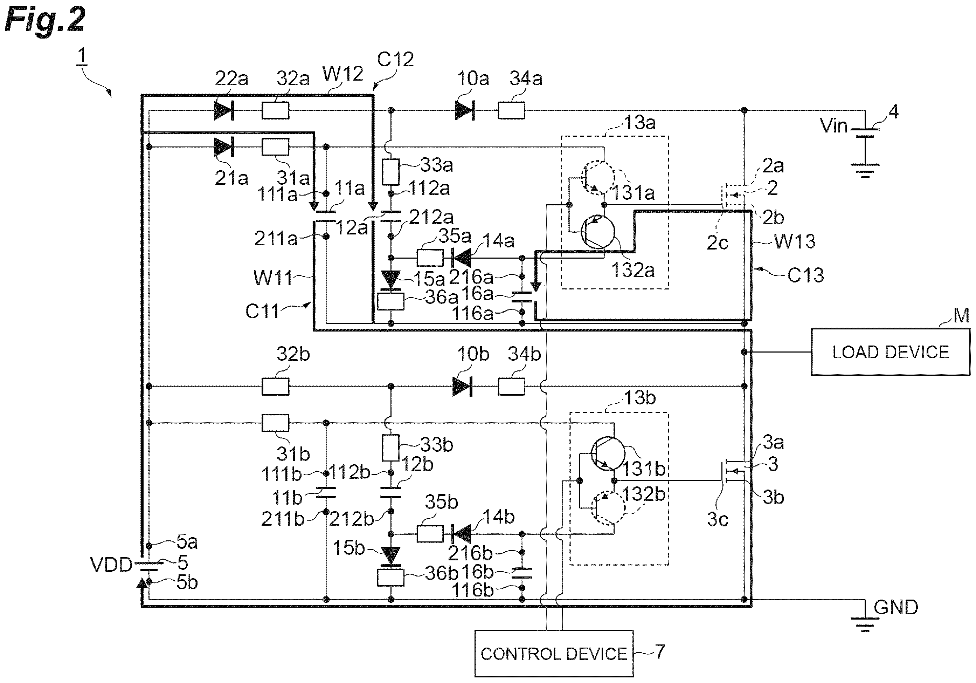

Upon receiving a control signal instructing the off state of the semiconductor switch 2, the connection switching portion 13a is controlled to a second connection state in which the switch 131a is in an off state and the switch 132a is in an on state. In the second connection state, a negative voltage application closed circuit C13 for applying a negative voltage of the capacitor 16a to the gate terminal 2c of the semiconductor switch 2, a positive voltage charging closed circuit C11 that charges the capacitor 11a with a positive voltage, and a temporary charging closed circuit C12 that temporarily charges the capacitor 12a with negative voltage-generating electric power are formed (see FIG. 2).

The negative voltage application closed circuit C13 is a closed circuit that passes a path W13 in FIG. 2. The negative voltage application closed circuit C13 is formed by the negative terminal 216a of the capacitor 16a being connected to the gate terminal 2c of the semiconductor switch 2 via the switch 132a in the on state. The negative voltage application closed circuit C13 includes, for example, the capacitor 16a, the switch 132a, and the semiconductor switch 2. In the negative voltage application closed circuit C13, the charge stored in the capacitor 16a is supplied to the semiconductor switch 2 through the switch 132a. A positive voltage is thus applied to the semiconductor switch 2 so that the semiconductor switch 2 is in the on state. In this case, the semiconductor switch 2 transitions from the on state to the off state by the charge stored in the input capacitance of the semiconductor switch 2 being discharged. In other words, a negative voltage is applied to the gate terminal 2c of the semiconductor switch 2 by the negative charge stored in the capacitor 16a being supplied to the gate terminal 2c of the semiconductor switch 2. The semiconductor switch 2 is thus in the off state.

The positive voltage charging closed circuit C11 is a closed circuit that passes a path W11 in FIG. 2. The positive voltage charging closed circuit C11 is formed by the negative terminal 211a of the capacitor 11a being connected to a negative terminal 5b of the drive power source 5 via the semiconductor switch 3 in the on state. The positive voltage charging closed circuit C11 includes, for example, the drive power source 5, the diode 21a, the resistive element 31a, the capacitor 11a, and the semiconductor switch 3. In the positive voltage charging closed circuit C11, the capacitor 11a is charged with the voltage VDD from the drive power source 5. In the positive voltage charging closed circuit C11, the charge from the drive power source 5 flows so as to pass through the resistive element 31a. The resistive element 31a thus has the function of limiting the charging current from the drive power source 5 to the capacitor 11a. Consequently, the charging current to the capacitor 11a can be adjusted by adjusting the resistance value of the resistive element 31a.

The temporary charging closed circuit C12 is a closed circuit that passes a path W12 in FIG. 2. The temporary charging closed circuit C12 is formed by the negative terminal 212a of the capacitor 12a being connected to the negative terminal 5b of the drive power source 5 via the semiconductor switch 3 in the on state. The temporary charging closed circuit C12 includes, for example, the drive power source 5, the diode 22a, the resistive element 32a, the capacitor 12a, and the semiconductor switch 3. In the temporary charging closed circuit C12, the capacitor 12a is charged with the voltage VDD from the drive power source 5. In the temporary charging closed circuit C12, the charge from the drive power source 5 flows so as to pass through the resistive element 32a, the resistive element 33a, and the resistive element 36a. The resistive element 32a, the resistive element 33a, and the resistive element 36a thus have the function of limiting the charging current from the drive power source 5 to the capacitor 12a. Consequently, the charging current to the capacitor 12a can be adjusted by adjusting the combined resistance value of the resistive element 32a, the resistive element 33a, and the resistive element 36a. The resistive element 33a has both the function of adjusting the charging current to the capacitor 12a as well as the function of adjusting the charging current to the capacitor 16a described above.

The connection switching portion 13a thus alternately switches, according to the control signal, between the first connection state in which the positive voltage application closed circuit C14 and the negative voltage charging closed circuit C15 are formed, and a second connection state in which the negative voltage application closed circuit C13, the positive voltage charging closed circuit C11, and the temporary charging closed circuit C12 are formed. In the first connection state, a positive voltage for turning on the semiconductor switch 2 is applied to the gate terminal 2c of the semiconductor switch 2 by the positive voltage application closed circuit C14. In the second connection state, a negative voltage for turning off the semiconductor switch 2 is applied to the gate terminal 2c of the semiconductor switch 2 by the negative voltage application closed circuit C13. Consequently, the semiconductor switch 2 can be alternately switched on or off by the connection switching portion 13a alternately switching between the first connection state and the second connection state.

The semiconductor switch drive portion 6a according to this embodiment is provided with a transfer restricting portion 50a (see FIG. 1) that restricts the transfer of charge from the path W14 that passes through the positive voltage application closed circuit C14 to other paths that pass through the positive terminal 111a of the capacitor 11a and not through the gate terminal 2c of the semiconductor switch 2. The transfer restricting portion 50a is provided between the positive terminal 111a of the capacitor 11a and the drain terminal 2a of the semiconductor switch 2. The transfer restricting portion 50a adjusts the transfer path of the charge of the capacitor 11a to prevent the transfer of the charge of the capacitor 11a from the path W14 that passes through the positive voltage application closed circuit C14 to paths other than the path W14. It is only required that the "other path" is a path that passes through the positive terminal 111a of the capacitor 11a and not through the gate terminal 2c of the semiconductor switch 2, and is a path other than the path W14 that passes through the positive terminal 111a of the capacitor 11a and passes through the gate terminal 2c of the semiconductor switch 2. For example, the "other path" may be a path from the positive terminal 111a of the capacitor 11a that passes through the drain terminal 2a of the semiconductor switch 2, and returns to the positive terminal 111a of the capacitor 11a.

The transfer restricting portion 50a includes, for example, the connection point P1a (an example of "third connection point"), the connection point P2a (an example of "first connection point"), the connection point P3a (an example of "second connection point"), the wire L2a (an example of "first wire"), the wire L5a (an example of "second wire"), the diode 21a (an example of "first diode"), the diode 22a (an example of "second diode"), the resistive element 31a (an example of "first resistive element"), and the resistive element 32a (an example of "second resistive element"). The connection point P1a is a branching point at which the wire connected to the positive terminal 5a of the drive power source 5 splits into the wire L2a and the wire L5a. The connection point P1a is positioned closer to the drive power source 5 than the connection point P2a in the wire between the positive terminal 5a of the drive power source 5 and the positive terminal 111a of the capacitor 11a. The wire L2a that joins the connection point P1a and the connection point P2a is connected, at the connection point P2a, to the wire L3a that forms the positive voltage application closed circuit C14.

The connection point P3a is positioned closer to the drive power source 5 than the connection point P5a in the wire between the positive terminal 5a of the drive power source 5 and the positive terminal 112a of the capacitor 12a. The wire L5a that joins the connection point P1a and the connection point P3a is connected to the wire L6a at the connection point P3a. The connection point P2a is not directly connected to the wire L5a or the wire L6a. Consequently, after the connection point P1a which is the branching point between the wire L2a and the wire L5a, the wire L2a and the wire L3a are independent of the wire L5a and the wire L6a, and do not have connection points with the wire L5a and the wire L6a.

In this case, the paths along which the charge stored in the capacitor 11a can be transferred in the first connection state are narrowed down to the path from the positive terminal 111a of the capacitor 11a to the wire L3a via the connection point P2a, and the path from the positive terminal 111a of the capacitor 11a to the wire L2a via the connection point P2a. Here, the transfer of the charge from the connection point P2a to the connection point P1a is restricted since the backflow prevention diode 21a is provided in the wire L2a. Consequently, the path along which the charge is transferred from the connection point P2a to the connection point P3a is eliminated.

As a result, in the first connection state, the charge is prevented from being transferred from the path W14 of the positive voltage application closed circuit C14 to other paths such as the path in which the charge of the capacitor 11a is transferred through the capacitor 12a via the connection point P3a, or the path in which the charge of the capacitor 11a is transferred through the drain terminal 2a of the semiconductor switch 2 via the connection point P3a. Thus, in the first connection state, the charge of the capacitor 11a is only transferred along the path W14 that passes through the wire L3a and the gate terminal 2c of the semiconductor switch 2. Thus, in this embodiment, the transfer restricting portion 50a prevents the charge of the capacitor 11a from being transferred from the path W14 of the positive voltage application closed circuit C14 to other paths in the first connection state.

The semiconductor switch drive portion 6b has components similar to those of the semiconductor switch drive portion 6a, with the exception that it does not include circuit elements corresponding to the diode 21a and the diode 22a. When the parts of the reference signs given to the components of the semiconductor switch drive portion 6b, excluding the suffix "b," are the same as the parts of the reference signs given to the components of the semiconductor switch drive portion 6a, excluding the suffix "a," it means that the components represented by those reference signs are the same. Accordingly, the detailed description of the components of the semiconductor switch drive portion 6b is omitted as it overlaps with the description of the components of the semiconductor switch drive portion 6a.

Unlike in the semiconductor switch drive portion 6a that forms the upper arm, in the semiconductor switch drive portion 6b that forms the lower arm, circuit elements corresponding to the diode 21a and the diode 22a can be omitted since it is not assumed that the charge flows back to the drive power source 5 due to the voltage balance. Normally, the voltage VDD (e.g., 15 V) of the drive power source 5 for driving the semiconductor switch 2 and the semiconductor switch 3 is lower than the input voltage Vin (e.g., 300 V) of the power source 4 for driving the load device M.

In the first connection state (i.e., a case in which the semiconductor switch 2 is in the on state and the semiconductor switch 3 is in the off state), the negative terminal 211a of the capacitor 11a is connected to the power source 4 via the semiconductor switch 2. Consequently, a relatively high input voltage Vin is applied to the negative terminal 211a of the capacitor 11a. The positive terminal 111a of the capacitor 11a is connected to the positive terminal 5a of the drive power source 5. Consequently, a relatively low voltage VDD is applied to the positive terminal 111a of the capacitor 11a. This may cause the electric current to flow back from the power source 4 to the drive power source 5 due to the difference in the voltages of the input voltage Vin and the voltage VDD in the upper arm. It is thus necessary to provide the diode 21a and the diode 22a to prevent such backflow.

However, backflow from the power source 4 to the drive power source 5 is prevented by a diode 10b in the lower arm, so that the voltage VDD of the power source 4 is not applied to the capacitor 11a, or the like. Additionally, a GND potential is constantly applied to the negative terminal 5b of the drive power source 5, and the like. Thus, in the lower arm, the electric current does not flow back from the power source 4 to the drive power source 5 due to the difference in the voltages of the input voltage Vin and the voltage VDD. This eliminates the need to provide circuit elements corresponding to the diode 21a and the diode 22a. However, the semiconductor switch drive portion 6b of the lower arm may be provided with circuit elements corresponding to the diode 21a and the diode 22a similarly to the semiconductor switch drive portion 6a of the upper arm. In this case, these circuit elements can function as backup in case the diode 10b is damaged. The semiconductor switch drive portion 6b may also have configurations different from those of the semiconductor switch drive portion 6a other than the diode 21a and the diode 22a.

### [Operation of Semiconductor Switch Drive Circuit]

The flow of operation of the semiconductor switch drive circuit 6 will be described next. In this embodiment, the semiconductor switch drive circuit 6 has a first operation mode in which the connection switching portion 13a of the semiconductor switch drive portion 6a is in the second connection state, and a connection switching portion 13b of the semiconductor switch drive portion 6b is in the first connection state, and a second operation mode in which the connection switching portion 13a of the semiconductor switch drive portion 6a is in the first connection state, and the connection switching portion 13b of the semiconductor switch drive portion 6b is in the second connection state. The semiconductor switch drive circuit 6 alternately switches between the first operation mode and the second operation mode according to a control signal from the control device 7 to drive the semiconductor switch 2 and the semiconductor switch 3 such that they are alternately in the on state.

The operation of the semiconductor switch drive portion 6a that switches the semiconductor switch 2 on or off will first be described with reference to FIGS. 2 and 3. In FIGS. 2 and 3, the semiconductor switch 2, the semiconductor switch 3, the switch 131a, the switch 132a, a switch 131b, and a switch 132b shown in dashed lines indicate that they are off. The semiconductor switch 2, the semiconductor switch 3, the switch 131a, the switch 132a, the switch 131b, and the switch 132b shown in solid lines indicate that they are on. The capacitor 16a is charged with charge prior to the implementation of the first operation mode.

### <First Operation Mode>

In the first operation mode, the connection switching portion 13a is in the second connection state, so that the negative voltage application closed circuit C13 is formed by the connection between the capacitor 16a and the semiconductor switch 2 as illustrated in FIG. 2. In the negative voltage application closed circuit C13, the charge stored in the capacitor 16a passes along the path W13 which returns to the capacitor 16a through the semiconductor switch 2. The semiconductor switch 2 is turned to the off state by the negative voltage of the capacitor 16a being supplied to the gate terminal 2c of the semiconductor switch 2.

In the first operation mode, the positive voltage charging closed circuit C11 is formed by the connection between the capacitor 11a and the drive power source 5. In the positive voltage charging closed circuit C11, the electric current from the drive power source 5 flows through the path W11 which returns to the drive power source 5 through the capacitor 11a and the semiconductor switch 3. The capacitor 11a is charged by this electric current. In the first operation mode, the temporary charging closed circuit C12 is formed by the connection between the capacitor 12a and the drive power source 5. In the temporary charging closed circuit C12, the electric current from the drive power source 5 flows through the path W12 which returns to the drive power source 5 through the capacitor 12a and the semiconductor switch 3. The capacitor 12a is charged by this electric current.

### <Second Operation Mode>

In the second operation mode, the connection switching portion 13a is in the first connection state, so that the positive voltage application closed circuit C14 is formed by the connection between the capacitor 11a and the semiconductor switch 2 as illustrated in FIG. 3. In the positive voltage application closed circuit C14, the charge stored in the capacitor 11a passes along the path W14 which returns to the capacitor 11a through the semiconductor switch 2. The semiconductor switch 2 transitions from the off state to the on state by the positive charge of the capacitor 11a being supplied to the gate terminal 2c of the semiconductor switch 2.

In the second operation mode, the negative voltage charging closed circuit C15 is formed by the connection between the capacitor 12a and the capacitor 16a. In the negative voltage charging closed circuit C15, the charge stored in the capacitor 12a flows through the path W15 which returns to the capacitor 12a through the semiconductor switch 2 and the capacitor 16a. The capacitor 16a is thus charged.

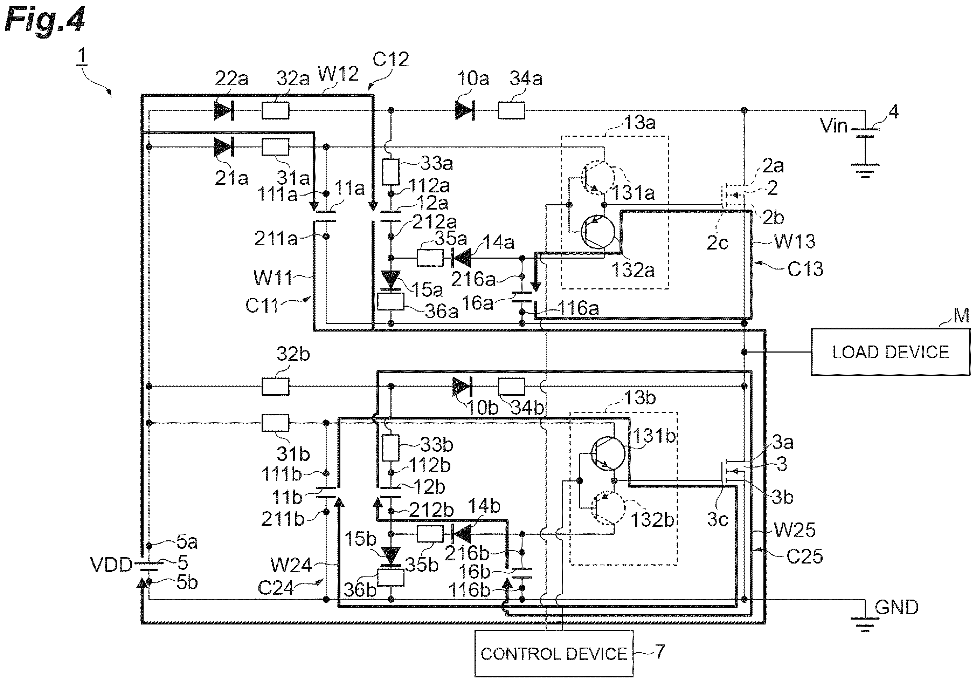

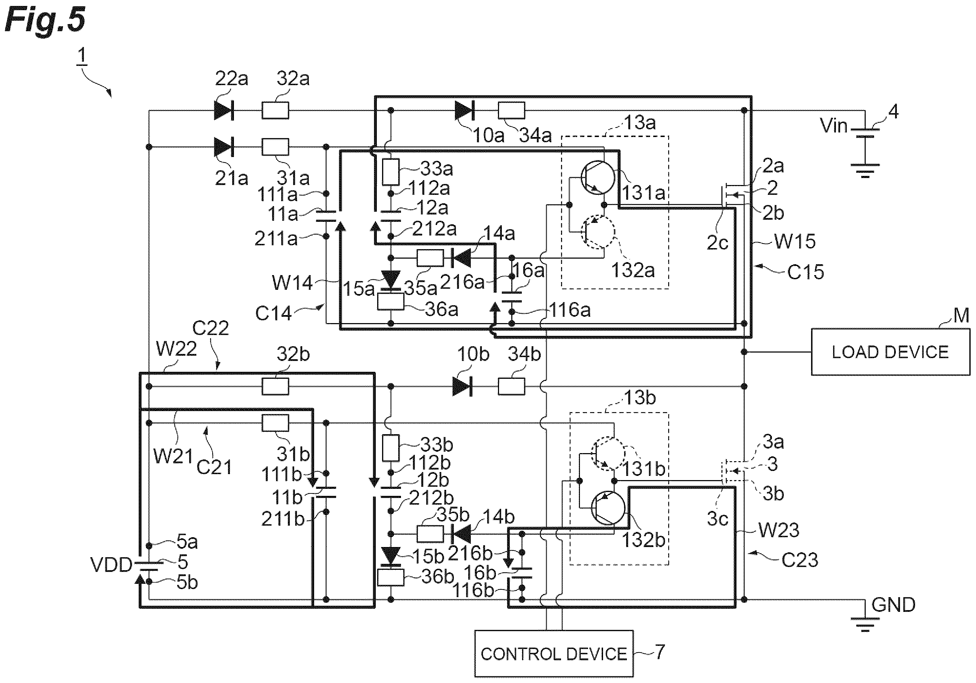

The operation of the semiconductor switch drive portion 6b that switches the semiconductor switch 3 on or off will be described next with reference to FIGS. 4 and 5. In FIGS. 4 and 5, the semiconductor switch 2, the semiconductor switch 3, the switch 131a, the switch 132a, the switch 131b, and the switch 132b shown in dashed lines indicate that they are off, and the semiconductor switch 2, the semiconductor switch 3, the switch 131a, the switch 132a, the switch 131b, and the switch 132b shown in solid lines indicate that they are on. The capacitor 16a is charged with charge prior to the implementation of the first operation mode.

### <First Operation Mode>

In the first operation mode, the connection switching portion 13b of the semiconductor switch drive portion 6b is in the first connection state, so that a positive voltage application closed circuit C24 is formed by the connection between a capacitor 11b and the semiconductor switch 3 as illustrated in FIG. 4. In the positive voltage application closed circuit C24, the charge stored in the capacitor 11b passes along a path W24 which returns to the capacitor 11b through the semiconductor switch 3. The semiconductor switch 3 is turned to the on state by the positive charge of the capacitor 11b being supplied to the gate terminal 2c of the semiconductor switch 3.

In the first operation mode, a negative voltage charging closed circuit C25 is formed by the connection between a capacitor 12b and a capacitor 16b. In the negative voltage charging closed circuit C25, the charge stored in the capacitor 12b flows through a path W25 which returns to the capacitor 12b through the semiconductor switch 3 and the capacitor 16b. The capacitor 16b is thus charged.

### <Second Operation Mode>

In the second operation mode, the connection switching portion 13b of the semiconductor switch drive portion 6b is in the second connection state, so that a negative voltage application closed circuit C23 is formed by the connection between the capacitor 16b and the semiconductor switch 3 as illustrated in FIG. 5. In the negative voltage application closed circuit C23, the charge stored in the capacitor 16b passes along a path W23 which returns to the capacitor 16b through the semiconductor switch 3. The semiconductor switch 3 is turned to the off state by the negative voltage of the capacitor 16b being supplied to the gate terminal 2c of the semiconductor switch 3.

In the second operation mode, a positive voltage charging closed circuit C21 is formed by the connection between the capacitor 11b and the drive power source 5. In the positive voltage charging closed circuit C21, the electric current from the drive power source 5 flows through a path W21 which returns to the drive power source 5 through the capacitor 11b and the semiconductor switch 3. The capacitor 11b is charged by this electric current. In the first operation mode, a temporary charging closed circuit C22 is formed by the connection between the capacitor 12b and the drive power source 5. In the temporary charging closed circuit C22, the electric current from the drive power source 5 flows through a path W22 which returns to the drive power source 5 through the capacitor 12b and the semiconductor switch 3. The capacitor 12b is charged by this electric current.

### [Operation and Effects]

The operation and effects produced by the semiconductor switch drive circuit 6 and the power converter 1 according to this embodiment will be described next together with the problem of a comparative example.

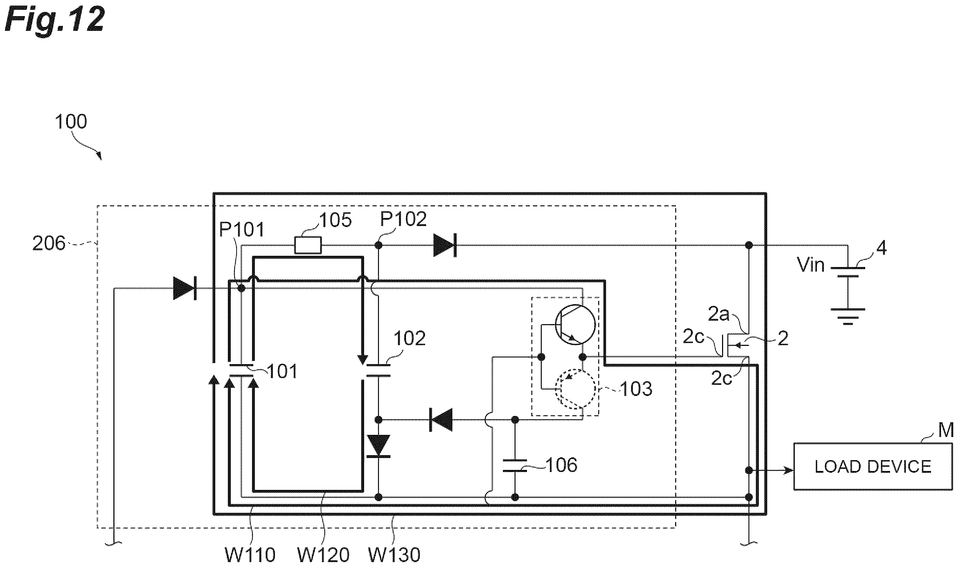

FIG. 12 illustrates an upper arm drive circuit 206 of a power converter 100 according to the comparative example. Unlike the semiconductor switch drive portion 6a according to this embodiment, the drive circuit 206 does not have the transfer restricting portion 50a. In the first connection state in this case, other than a path W110 which returns to the capacitor 101 through the gate terminal 2c of the semiconductor switch 2, the charge stored in a capacitor 101 passes along a path W120 in which the charge is transferred from a connection point P101 to a connection point P102 and passes through a capacitor 102, and a path W130 in which the charge is transferred from the connection point P101 to the connection point P102 and passes through the drain terminal 2a of the semiconductor switch 2.

Since the charge of the capacitor 101 thus passes along the path W120 that passes through the gate terminal 2c of the semiconductor switch 2, in a case in which the charge is transferred to the other path W120 or path W130 that passes through the capacitor 101 and the gate terminal 2c of the semiconductor switch 2, the positive voltage of the capacitor 101 is divided between the semiconductor switch 2 and other circuit elements which reduces the positive voltage applied to the semiconductor switch 2. For example, in the path W120, the positive voltage of the capacitor 101 is divided between a resistive element 105, the capacitor 102, and the semiconductor switch 2. In the path W130, the positive voltage of the capacitor 101 is divided between the resistive element 105 and the semiconductor switch 2. In particular, in the path W130, the electric power of the capacitor 101 is wasted, since the charge of the capacitor 101 is consumed by the resistive element 105 and passes along the path returning to the capacitor 101 without contributing to the charging of the capacitor 102.

However, this embodiment is provided with the transfer restricting portion 50a that restricts the transfer of the charge of the capacitor 11a from the path W14 of the positive voltage application closed circuit C14 to other paths. This makes it possible to prevent the charge of the capacitor 11a from passing along the other paths such as the path W120 and the path W130 described above, so that it is possible to prevent the positive voltage of the capacitor 11a from being divided between the circuit elements in the path W14 of the positive voltage application closed circuit C14 and the other paths. It is thus possible to efficiently suppress the reduction in the positive voltage from the capacitor 11a to the semiconductor switch 2. Consequently, the semiconductor switch drive circuit 6 is capable of supplying enough charge to the gate terminal 2c of the semiconductor switch 2 when turning on the semiconductor switch 2. That is, the semiconductor switch drive circuit 6 is capable of reliably controlling the semiconductor switch 2 to be turned on.

This embodiment is provided with the capacitor 12a for charging the capacitor 16a. This eliminates the need to arrange the capacitor 16a in the positive voltage application closed circuit C14, in which the positive voltage of the capacitor 11a is applied to a control terminal of the semiconductor switch 2, to charge the capacitor 16a. That is, the path W14 along which the charge of the capacitor 11a is transferred in the positive voltage application closed circuit C14 is a path that does not pass through the capacitor 16a. This prevents the positive voltage of the capacitor 11a from being divided between the semiconductor switch 2 and the capacitor 16a. In this embodiment, the path W11 along which the charge of the capacitor 11a is transferred in the positive voltage charging closed circuit C11 and the path W12 along which the charge of the capacitor 12a is transferred in the temporary charging closed circuit C12 are each a path that does not pass through the capacitor 16a. The voltage VDD of the drive power source 5 is thus applied to the capacitor 11a without being divided by the capacitor 16a. Similarly, the voltage VDD of the drive power source 5 is applied to the capacitor 11a without being divided by the capacitor 16a.

Consequently, the reduction in the positive voltage to the semiconductor switch 2 is efficiently suppressed in this embodiment. In this embodiment, a positive voltage is generated in the capacitor 11a by the electric power from the drive power source 5, and a negative voltage is generated in the capacitor 16a by the electric power discharged from the capacitor 12a in a charged state. That is, the positive voltage and the negative voltage are generated using the single drive power source 5. This eliminates the need to separately provide the drive power source 5 for generating a negative voltage, so that an increase in the size and weight of a device configuration is suppressed.

The transfer restricting portion 50a may, such as in this embodiment, have the connection point P2a between the positive terminal 111a of the capacitor 11a and the gate terminal 2c of the semiconductor switch 2, the connection point P3a between the positive terminal 112a of the capacitor 12a and the drain terminal 2a of the semiconductor switch 2, the connection point P1a between the connection point P2a and the positive terminal 5a of the drive power source 5, the wire L2a connecting the connection point P2a and the connection point P1a, and the wire L5a connecting the connection point P3a and the connection point P1a. In the case in which the connection point P1a is provided between the connection point P2a and the drive power source 5 in this way, it is possible to prevent the charge released from the capacitor 11a from being transferred to the connection point P3a via the connection point P2a and the connection point P1a, while allowing the charge to be transferred from the drive power source 5 to the capacitor 11a through the connection point P1a and the connection point P2a. This makes it possible to prevent the charge of the capacitor 11a transferred along the path W14 of the positive voltage application closed circuit C14 from being transferred to the other paths from the connection point P2a through the connection point P3a. As a result, the division of the positive voltage of the capacitor 11a between the circuit elements in the path W14 of the positive voltage application closed circuit C14 and the other paths can be more effectively suppressed, and the reduction in the positive voltage to the semiconductor switch 2 can be more effectively suppressed.

The transfer restricting portion 50a may, such as in this embodiment, have the diode 21a which is connected with the direction from the connection point P1a toward the connection point P2a as the forward direction in the wire L2a, and the diode 22a which is connected with the direction from the connection point P1a toward the connection point P3a as the forward direction in the wire L5a. Having the diode 21a and the diode 22a provided in this way prevents backflow of the charge from the capacitor 11a and the capacitor 12a to the drive power source 5. Furthermore, having the diode 21a provided between the connection point P1a and the connection point P2a prevents the charge of the capacitor 11a from being transferred from the connection point P2a to the connection point P3a through the connection point P1a. This makes it possible to more effectively suppress the division of the positive voltage of the capacitor 11a between the circuit elements in the path W14 of the positive voltage application closed circuit C14 and the other paths. Thus, since the transfer of the charge of the capacitor 11a to the other paths through the connection point P3a is prevented, it is possible to more effectively suppress the reduction in the positive voltage from the capacitor 11a to the semiconductor switch 2.

The transfer restricting portion 50a may, such as in this embodiment, have the resistive element 31a which is connected in series with the diode 21a in the wire L2a, and the resistive element 32a which is connected in series with the diode 22a in the wire L5a, and has a resistance value that is higher than the resistance value of the resistive element 31a. The negative voltage for turning the semiconductor switch 2 to the off state tends to be smaller than the positive voltage for turning the semiconductor switch 2 to the on state. In the case in which the negative voltage is smaller in this way, the amount of charge of the capacitor 12a storing the electric power for generating a negative voltage may be less than the amount of charge of the capacitor 11a storing the electric power for generating a positive voltage. Thus, in the configuration described above, the resistive element 32a provided in the transfer path of the charge flowing from the drive power source 5 to the capacitor 12a has a resistance value higher than the resistance value of the resistive element 31a provided in the transfer path of the charge flowing from the drive power source 5 to the capacitor 11a. This makes it possible to minimize the charging current supplied from the drive power source 5 to the capacitor 12a. As a result, it is possible to suppress an increase in the capacity of the drive power source 5 that provides the capacitor 12a with electric power.

The positive terminal 111a of the capacitor 11a may, such as in this embodiment, be connected to the positive terminal 5a of the drive power source 5 and the gate terminal 2c of the semiconductor switch 2. The positive terminal 112a of the capacitor 12a may be connected to the positive terminal 5a of the drive power source 5. The negative terminal 216a of the capacitor 16a may be connected to the negative terminal 212a of the capacitor 12a. The positive terminal 116a of the capacitor 16a may be connected to the gate terminal 2c of the semiconductor switch 2. In this case, the configuration of generating the positive voltage and the negative voltage using the single drive power source 5 can be easily achieved.

The semiconductor switch drive portion 6a and the semiconductor switch drive portion 6b may, such as in this embodiment, have the transfer restricting portion 50a and a transfer restricting portion 50b, respectively. In this case, the reduction in the positive voltage to the semiconductor switch 2 and the semiconductor switch 3 can be effectively suppressed in both the upper arm and the lower arm.

The semiconductor switch drive portion 6b may, such as in this embodiment, have the same configuration as that of the semiconductor switch drive portion 6a, with the exception that it does not include circuit elements corresponding to the diode 21a and the diode 22a. As described above, the charge may flow back to the drive power source 5 according to whether the semiconductor switch 2 is on or off in the upper arm. In the lower arm, however, the charge does not flow back to the drive power source 5 regardless of whether the semiconductor switch 3 is on or off. Thus, in this embodiment, the semiconductor switch drive portion 6a that forms the upper arm is provided with the diode 21a and the diode 22a, but the semiconductor switch drive portion 6b that forms the lower arm is not provided with any circuit elements corresponding to the diode 21a and the diode 22a. This makes it possible to reduce the number of components that form the semiconductor switch drive portion 6b.

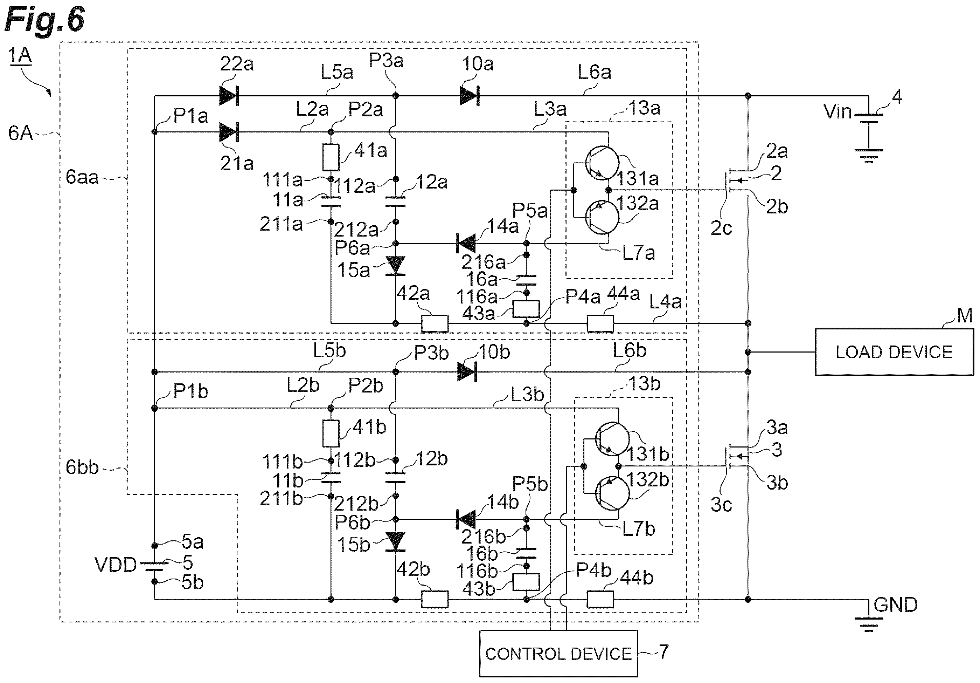

The semiconductor switch drive circuit 6 is not limited to the circuit configuration described above, and may have other circuit configurations. For example, in place of the semiconductor switch drive circuit 6, a semiconductor switch drive circuit 6A in which the arrangement of the resistive elements is different may be provided, as in a power converter 1A illustrated in FIG. 6. A semiconductor switch drive portion 6aa (an example of "first semiconductor switch drive portion") of the semiconductor switch drive circuit 6A includes a resistive element 41a, a resistive element 42a, a resistive element 43a, and a resistive element 44a in place of the resistive element 31a, the resistive element 32a, the resistive element 33a, the resistive element 34a, the resistive element 35a, and the resistive element 36a.

The resistive element 41a is connected in series between the positive terminal 111a of the capacitor 11a and the connection point P2a. The resistive element 41a is, for example, a limiting resistance that limits the charging current from the drive power source 5 to the capacitor 11a, and the gate current (positive voltage) from the capacitor 11a to the semiconductor switch 2. The resistive element 42a is connected in series between the negative terminal 211a of the capacitor 11a and the connection point P4a. The resistive element 42a is, for example, a limiting resistance that limits the charging current from the drive power source 5 to the capacitor 11a, the charging current from the drive power source 5 to the capacitor 12a, and the gate current (positive voltage) from the capacitor 11a to the semiconductor switch 2.

The resistive element 43a is connected in series between the positive terminal 116a of the capacitor 16a and the connection point P4a. The resistive element 43a is, for example, a limiting resistance that limits the charging current from the capacitor 12a to the capacitor 16a, and the gate current (negative voltage) from the capacitor 16a to the semiconductor switch 2. The resistive element 44a is connected in series between the connection point P4a and the source terminal 2b of the semiconductor switch 2. The resistive element 44a is, for example, a limiting resistance that limits the charging current from the drive power source 5 to the capacitor 11a, the charging current from the drive power source 5 to the capacitor 12a, the charging current from the capacitor 12a to the capacitor 16a, and the gate current (negative voltage) from the capacitor 16a to the semiconductor switch 2.

A semiconductor switch drive portion 6bb (an example of "second semiconductor switch drive portion") of the semiconductor switch drive circuit 6A includes a resistive element 41b, a resistive element 42b, a resistive element 43b, and a resistive element 44b corresponding to the resistive element 41a, the resistive element 42a, the resistive element 43a, and the resistive element 44a, respectively. Effects similar to those described above can also be produced by the semiconductor switch drive circuit 6A having such a circuit configuration.

### [Second Embodiment]

A second embodiment will be described next. In the description of the second embodiment below, the sections that differ from the first embodiment will be mainly described with the description of the sections overlapping the first embodiment omitted as appropriate.

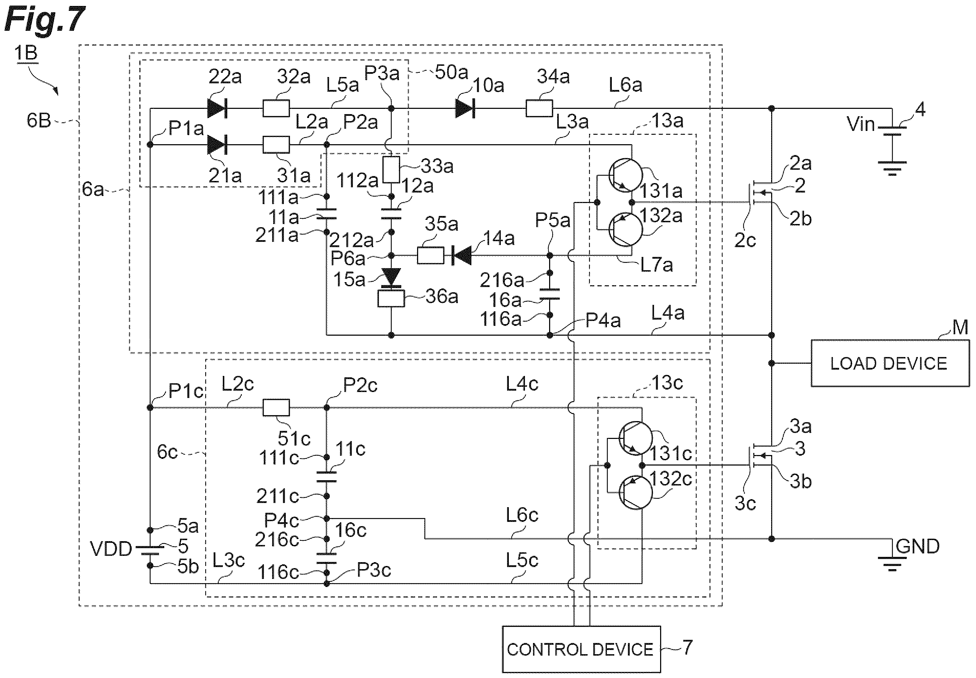

As illustrated in FIG. 7, a power converter 1B according to the second embodiment includes a semiconductor switch drive circuit 6B in place of the semiconductor switch drive circuit 6. The semiconductor switch drive circuit 6B is different from the semiconductor switch drive circuit 6 in that it has a semiconductor switch drive portion 6c in place of the semiconductor switch drive portion 6b. The semiconductor switch drive portion 6c includes, for example, a connection switching portion 13c (an example of "another connection switching portion"), a capacitor 11c (an example of "fourth capacitor"), a capacitor 16c (an example of "fifth capacitor"), and a resistive element 51c.

The capacitor 11c is connected between the drive power source 5 and the connection switching portion 13c. The capacitor 11c is, for example, a positive power source capacitor that generates a positive voltage. A positive terminal 111c (one end) of the capacitor 11c is connected to the positive terminal 5a of the drive power source 5 via a wire L2c. The positive terminal 111c of the capacitor 11c is connected to the connection switching portion 13c via a wire L4c. A negative terminal 211 c (the other end) of the capacitor 11c is connected to the negative terminal 5b of the drive power source 5 via a wire L3c. The negative terminal 211 c of the capacitor 11c is connected to the connection switching portion 13c via a wire L5c.

The capacitor 16c is a negative power source capacitor that generates a negative voltage by receiving electric power from the capacitor 12c in a charged state. The capacitor 16c is connected in series with the capacitor 11c between a connection point P2c of the wire L2c and the wire L4c, and a connection point P3c of the wire L3c and the wire L5c. The capacitor 16c is connected between the capacitor 11c and the connection point P3c. A negative terminal 216c (other end) of the capacitor 16c is connected to the negative terminal 211c of the capacitor 11c. A positive terminal 116c (one end) of the capacitor 16c is connected to the connection point P3c. A connection point P4c between the negative terminal 216c of the capacitor 16c and the negative terminal 211c of the capacitor 11c is connected to the source terminal 3b of the semiconductor switch 3 via a wire L6c. The resistive element 51c is, for example, a limiting resistance that limits the electric current from the drive power source 5 to the capacitor 11c. The resistive element 51c is connected to the wire L2c between a connection point P1c connected to the positive terminal 5a of the drive power source 5 and the connection point P2c. One end of the resistive element 31c is connected to the positive terminal 5a of the drive power source 5. The other end of the resistive element 51c is connected to the positive terminal 111c of the capacitor 11c.

### [Operation of Semiconductor Switch Drive Circuit]

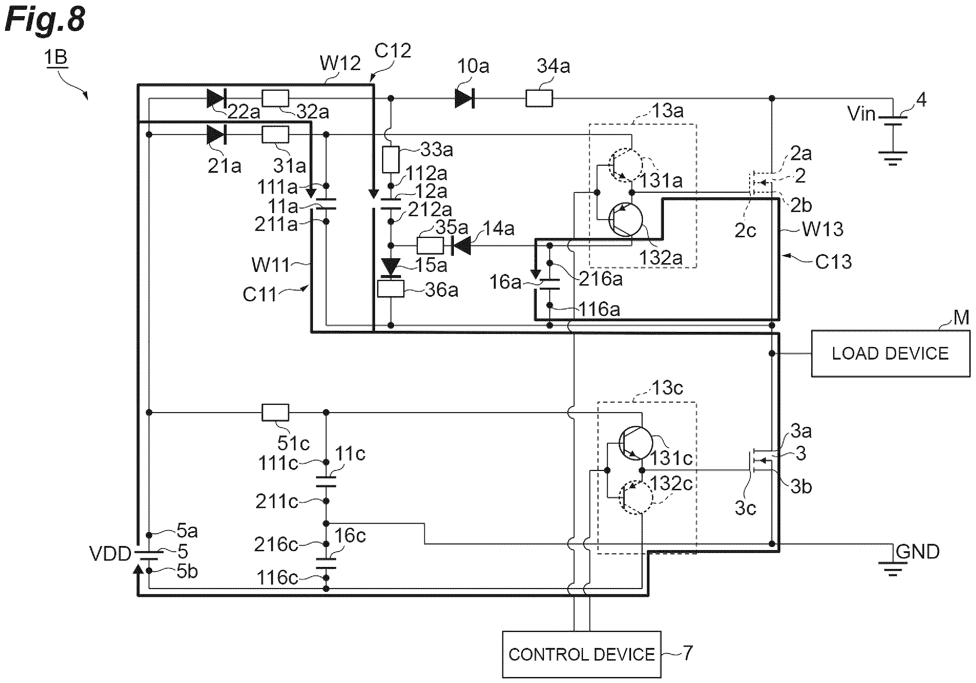

The flow of operation of the semiconductor switch drive circuit 6B will be described next with reference to FIGS. 8 to 11. In this embodiment, the semiconductor switch drive circuit 6B has a first operation mode in which the connection switching portion 13a of the semiconductor switch drive portion 6a is in the second connection state, and the connection switching portion 13c of the semiconductor switch drive portion 6c is in the first connection state, and a second operation mode in which the connection switching portion 13a of the semiconductor switch drive portion 6a is in the first connection state, and the connection switching portion 13c of the semiconductor switch drive portion 6c is in the second connection state. The semiconductor switch drive circuit 6 alternately switches between the first operation mode and the second operation mode according to a control signal from the control device 7 to drive the semiconductor switch 2 and the semiconductor switch 3 such that they are alternately in the on state.

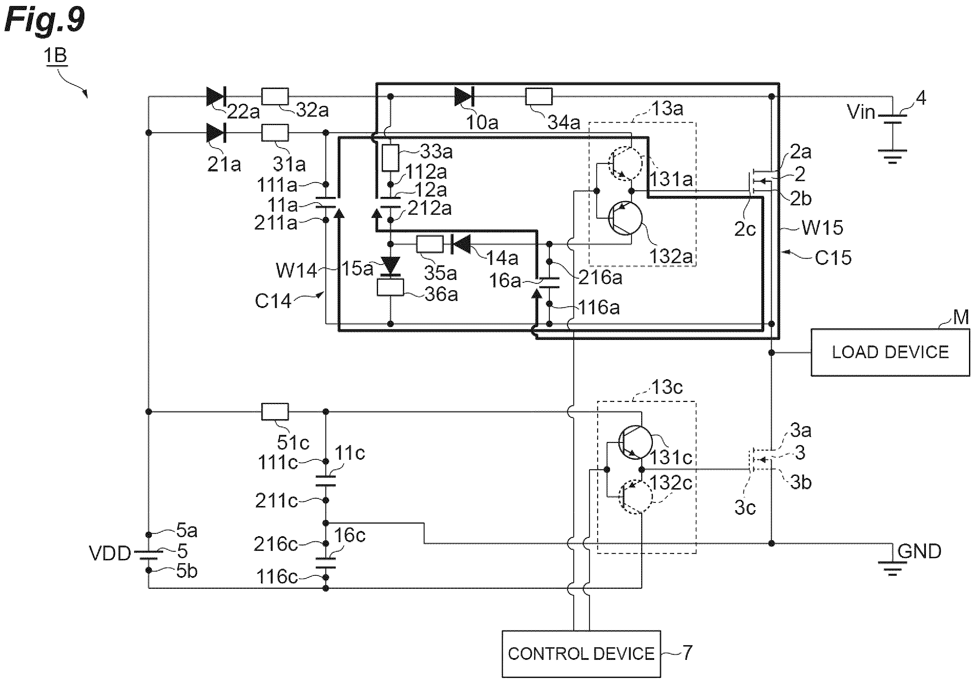

The operation of the semiconductor switch drive portion 6a that switches the semiconductor switch 2 on or off will be described with reference to FIGS. 8 and 9.

### <First Operation Mode>

In the first operation mode, the connection switching portion 13a is in the second connection state, so that the negative voltage application closed circuit C13 is formed by the connection between the capacitor 16a and the semiconductor switch 2 as illustrated in FIG. 8. In the negative voltage application closed circuit C13, the charge stored in the capacitor 16a passes along the path W13 which returns to the capacitor 16a through the semiconductor switch 2. The semiconductor switch 2 is turned to the off state by the negative voltage of the capacitor 16a being supplied to the gate terminal 2c of the semiconductor switch 2.

In the first operation mode, the positive voltage charging closed circuit C11 is formed by the connection between the capacitor 11a and the drive power source 5. In the positive voltage charging closed circuit C11, the electric current from the drive power source 5 flows through the path W11 which returns to the drive power source 5 through the capacitor 11a and the semiconductor switch 3. The capacitor 11a is charged by this electric current. In the first operation mode, the temporary charging closed circuit C12 is formed by the connection between the capacitor 12a and the drive power source 5. In the temporary charging closed circuit C12, the electric current from the drive power source 5 flows through the path W12 which returns to the drive power source 5 through the capacitor 12a and the semiconductor switch 3. The capacitor 12a is charged by this electric current.

### <Second Operation Mode>

In the second operation mode, the connection switching portion 13a is in the first connection state, so that the positive voltage application closed circuit C14 is formed by the connection between the capacitor 11a and the semiconductor switch 2 as illustrated in FIG. 9. In the positive voltage application closed circuit C14, the charge stored in the capacitor 11a passes along the path W14 which returns to the capacitor 11a through the semiconductor switch 2. The semiconductor switch 2 transitions from the off state to the on state by the positive charge of the capacitor 11a being supplied to the gate terminal 2c of the semiconductor switch 2. In the second operation mode, the negative voltage charging closed circuit C15 is formed by the connection between the capacitor 12a and the capacitor 16a. In the negative voltage charging closed circuit C15, the charge stored in the capacitor 12a flows through the path W15 which returns to the capacitor 12a through the semiconductor switch 2 and the capacitor 16a. The capacitor 16a is thus charged.

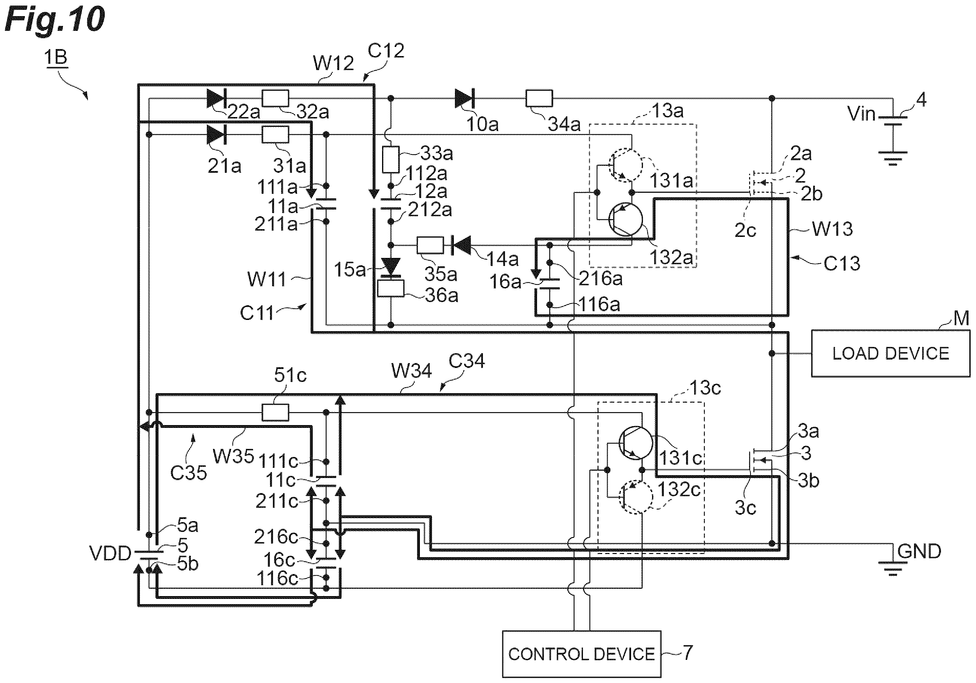

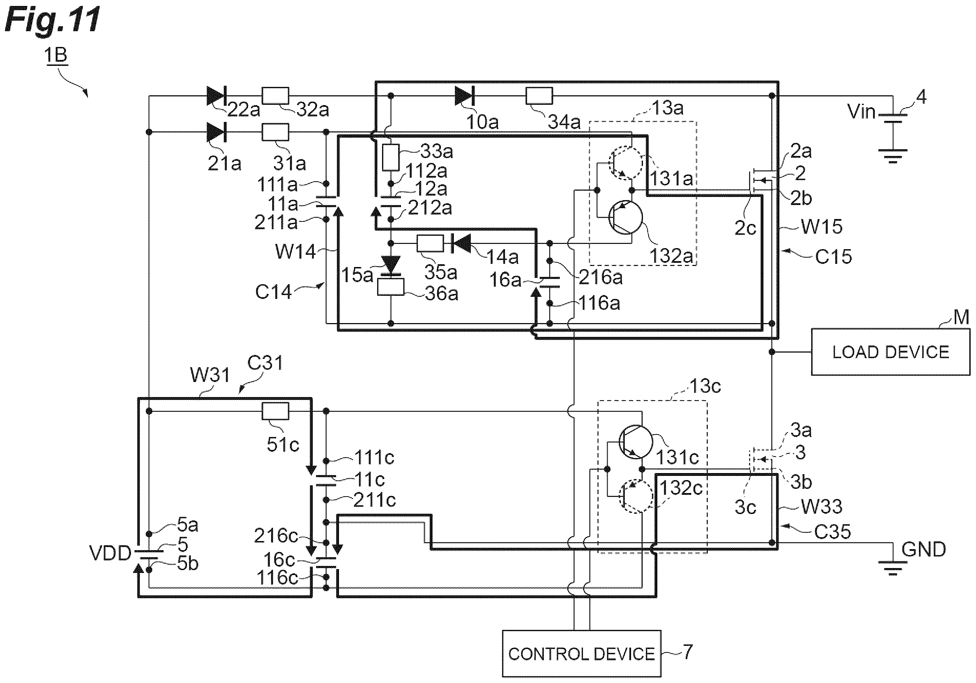

The operation of the semiconductor switch drive portion 6c that switches the semiconductor switch 3 on or off will be described next with reference to FIGS. 10 and 11.

### <First Operation Mode>

In the first operation mode, the connection switching portion 13c of the semiconductor switch drive portion 6c is in the first connection state (an example of "third connection state"), so that a positive voltage application closed circuit C34 (an example of "another positive voltage application closed circuit") is formed by the connection between the capacitor 11c and the semiconductor switch 3 as illustrated in FIG. 10. In the positive voltage application closed circuit C34, the charge stored in the capacitor 11c passes along a path W34 which returns to the capacitor 11c through the semiconductor switch 3. The semiconductor switch 3 is turned to the on state by the positive charge of the capacitor 11c being supplied to the gate terminal 2c of the semiconductor switch 3. In the first operation mode, a negative voltage charging closed circuit C35 is formed by the connection between the capacitor 11c and the capacitor 16c. In the negative voltage charging closed circuit C35, the charge stored in the capacitor 11c and the charge of the drive power source 5 flow through a path W35 which returns to the drive power source 5 through the capacitor 16c. The capacitor 16c is thus charged.

### <Second Operation Mode>

In the second operation mode, the connection switching portion 13c of the semiconductor switch drive portion 6c is in the second connection state (an example of "fourth connection state"), so that a negative voltage application closed circuit C33 (an example of "another negative voltage application closed circuit") is formed by the connection between the capacitor 16c and the semiconductor switch 3 as illustrated in FIG. 11. In the negative voltage application closed circuit C33, the charge stored in the capacitor 16c passes along a path W33 which returns to the capacitor 16c through the semiconductor switch 3. The semiconductor switch 3 is turned to the off state by the negative voltage of the capacitor 16c being supplied to the gate terminal 2c of the semiconductor switch 3. In the second operation mode, a positive voltage charging closed circuit C31 is formed by the connection between the capacitor 11c and the drive power source 5. In the positive voltage charging closed circuit C31, the electric current from the drive power source 5 flows through a path W31 which returns to the drive power source 5 through the capacitor 11c and the capacitor 16c. The capacitor 11c is charged by this electric current.

### [Operation and Effects]

The operation and effects produced by the semiconductor switch drive circuit 6B and the power converter 1B according to this embodiment will be described next. The semiconductor switch drive circuit 6B according to this embodiment includes the semiconductor switch drive portion 6a that is similar to the first embodiment, so that it is possible to achieve effects similar to those of the first embodiment. Furthermore, the semiconductor switch drive circuit 6B according to this embodiment includes the semiconductor switch drive portion 6c in place of the semiconductor switch drive portion 6b. In the semiconductor switch drive portion 6a that forms the upper arm, the charge state of the capacitor 11a is switched according to whether the semiconductor switch 2 is on or off, so that the voltage of the capacitor 11a tends to vary. In the semiconductor switch drive portion 6c that forms the lower arm, however, the capacitor 11c can be kept charged at all times, so that it is easy to maintain the voltage of the capacitor 11c constant. Thus, the lower arm employs a simplified circuit configuration in which no configurations corresponding to the capacitor 12a are provided, so that the number of components that form the semiconductor switch drive portion 6c can be reduced.

The present disclosure is not limited to the embodiments and variations described above, and many other variations are possible. For example, the embodiments and variations described above may be combined according to the required purpose and effects. The first embodiment above describes the case in which the semiconductor switch drive portion 6a and the semiconductor switch drive portion 6b are provided with the transfer restricting portion 50a and the transfer restricting portion 50b, respectively. However, the semiconductor switch drive portion 6a may be provided with the transfer restricting portion 50a, and the semiconductor switch drive portion 6b need not be provided with the transfer restricting portion 50b. The circuit configuration of the transfer restricting portion 50a is not limited to the example described above, and may be other circuit configurations as long as the transfer of the charge from the path W14 of the positive voltage application closed circuit C14 to other paths can be restricted.

The summary of the present disclosure is shown below.
[1] A semiconductor switch drive circuit including:
   a drive power source; and
   a semiconductor switch drive portion electrically connected to the drive power source, and configured to drive a semiconductor switch using electric power from the drive power source,
   wherein the semiconductor switch drive portion includes:
      a connection switching portion electrically connected between the drive power source and the semiconductor switch, and configured to switch a connection state of the semiconductor switch;
      a first capacitor electrically connected between the drive power source and the connection switching portion, and configured to generate a positive voltage for turning the semiconductor switch to an on state by being charged with the electric power from the drive power source;
      a second capacitor electrically connected in parallel with the first capacitor with respect to the drive power source, and configured to be charged with the electric power from the drive power source; and
      a third capacitor electrically connected between the second capacitor and the connection switching portion, and configured to generate a negative voltage for turning the semiconductor switch to an off state by being charged with electric power discharged from the second capacitor in a charged state,
      wherein the connection switching portion is configured to alternately switch between
      a first connection state forming a positive voltage application closed circuit configured to apply the positive voltage to a control terminal of the semiconductor switch by an electrical connection between a positive terminal of the first capacitor and the control terminal of the semiconductor switch, and
      a second connection state forming a negative voltage application closed circuit configured to apply the negative voltage to the control terminal of the semiconductor switch by an electrical connection between a negative terminal of the third capacitor and the control terminal of the semiconductor switch, and
      wherein a transfer restricting portion is provided between the first capacitor and the semiconductor switch, the transfer restricting portion configured to restrict transfer of electric charge of the first capacitor from a path passing through the positive voltage application closed circuit to another path passing through the positive terminal of the first capacitor and not through the control terminal of the semiconductor switch.
[2] The semiconductor switch drive circuit according to [1], wherein the transfer restricting portion includes:
   a first connection point between the positive terminal of the first capacitor and the control terminal of the semiconductor switch;
   a second connection point between a positive terminal of the second capacitor and an input terminal of the semiconductor switch;
   a third connection point arranged between the first connection point and a positive terminal of the drive power source, and electrically connected to the positive terminal of the drive power source;
   a first wire connecting the first connection point and the third connection point; and
   a second wire connecting the second connection point and the third connection point.
[3] The semiconductor switch drive circuit according to [2], wherein the transfer restricting portion further includes:
   a first diode connected with a direction from the third connection point toward the first connection point as a forward direction in the first wire; and
   a second diode connected with a direction from the third connection point toward the second connection point as a forward direction in the second wire.
[4] The semiconductor switch drive circuit according to [3], wherein the transfer restricting portion further includes:
   a first resistive element connected in series with the first diode in the first wire; and
   a second resistive element connected in series with the second diode in the second wire, and having a resistance value higher than a resistance value of the first resistive element.
[5] The semiconductor switch drive circuit according to any one of [1] to [4],
   wherein the positive terminal of the first capacitor is electrically connected to the positive terminal of the drive power source and the control terminal of the semiconductor switch,
   wherein the positive terminal of the second capacitor is electrically connected to the positive terminal of the drive power source,
   wherein the negative terminal of the third capacitor is electrically connected to a negative terminal of the second capacitor, and
   wherein a positive terminal of the third capacitor is electrically connected to the control terminal of the semiconductor switch.
[6] The semiconductor switch drive circuit according to any one of [1] to [5], including a first semiconductor switch drive portion and a second semiconductor switch drive portion being the semiconductor switch drive portion,
   wherein the first semiconductor switch drive portion and the second semiconductor switch drive portion are configured to respectively drive a first semiconductor switch and a second semiconductor switch being the semiconductor switch,
   wherein the first semiconductor switch forms an upper arm in the semiconductor switch drive circuit, and
   wherein the second semiconductor switch forms a lower arm in the semiconductor switch drive circuit, and is electrically connected in series with the first semiconductor switch.
[7] The semiconductor switch drive circuit according to [6],
   wherein the transfer restricting portion of each of the first semiconductor switch drive portion and the second semiconductor switch drive portion includes:
   the first connection point between the positive terminal of the first capacitor and the control terminal of the semiconductor switch;
   the second connection point between the positive terminal of the second capacitor and the input terminal of the semiconductor switch;
   the third connection point arranged between the first connection point and the positive terminal of the drive power source, and electrically connected to the positive terminal of the drive power source;
   the first wire connecting the first connection point and the third connection point; and
   the second wire connecting the second connection point and the third connection point, and
   wherein only the transfer restricting portion of the second semiconductor switch drive portion among the first semiconductor switch drive portion and the second semiconductor switch drive portion further includes:
      the first diode connected with the direction from the third connection point toward the first connection point as the forward direction in the first wire; and
      the second diode connected with the direction from the third connection point toward the second connection point as the forward direction in the second wire.
[8] The semiconductor switch drive circuit according to any one of [1] to [5], including a first semiconductor switch drive portion being the semiconductor switch drive portion, and configured to drive a first semiconductor switch being the semiconductor switch, and a second semiconductor switch drive portion electrically connected to the drive power source, and configured to drive a second semiconductor switch electrically connected in series with the first semiconductor switch using the electric power from the drive power source,
   wherein the first semiconductor switch forms an upper arm in the semiconductor switch drive circuit,
   wherein the second semiconductor switch forms a lower arm in the semiconductor switch drive circuit,
   wherein the second semiconductor switch drive portion includes:
      another connection switching portion electrically connected between the drive power source and the second semiconductor switch, and configured to switch a connection state of the second semiconductor switch;
      a fourth capacitor electrically connected between the drive power source and the other connection switching portion, and configured to generate a positive voltage for turning the second semiconductor switch to an on state by being charged with the electric power from the drive power source; and
      a fifth capacitor electrically connected in series between the fourth capacitor and the other connection switching portion, and configured to generate a negative voltage for turning the second semiconductor switch to an off state by being charged with electric power discharged from the fourth capacitor in a charged state, and
      wherein the other connection switching portion is configured to alternately switch between
      a first connection state forming a positive voltage application closed circuit configured to apply the positive voltage to a control terminal of the second semiconductor switch by an electrical connection between a positive terminal of the fourth capacitor and the control terminal of the second semiconductor switch, and
      a second connection state forming a negative voltage application closed circuit configured to apply the negative voltage to the control terminal of the second semiconductor switch by an electrical connection between a negative terminal of the fifth capacitor and the control terminal of the second semiconductor switch.
[9] A power converter for converting an aspect of electric power provided by a power source into an aspect of electric power required by a load device, the power converter including:
   the semiconductor switch electrically connected between the power source and the load device; and
   the semiconductor switch drive circuit according to any one of [1] to [8] electrically connected to the semiconductor switch, and configured to drive the semiconductor switch.

### Reference Signs List

1, 1A, 1B Power converter
2 Semiconductor switch (an example of "first semiconductor switch")
3 Semiconductor switch ("second semiconductor switch")
2a, 3a Drain terminal (an example of "input terminal")
2c, 3c Gate terminal (an example of "control terminal")
4 Power source
5 Drive power source
5a Positive terminal
5b Negative terminal
6, 6A, 6B Semiconductor switch drive circuit
6a, 6aa Semiconductor switch drive portion (an example of "first semiconductor switch drive portion")
6b, 6bb, 6c Semiconductor switch drive portion (an example of "second semiconductor switch drive portion")
11a Capacitor (an example of "first capacitor")
11c Capacitor (an example of "fourth capacitor")
12a Capacitor (an example of "second capacitor")
13a, 13b Connection switching portion
13c Connection switching portion (an example of "another connection switching portion")
16a Capacitor (an example of "third capacitor")
16c Capacitor (an example of "fifth capacitor")
21a Diode (an example of "first diode")
22a Diode (an example of "second diode")
31a Resistive element (an example of "first resistive element")
32a Resistive element (an example of "second resistive element")
50a, 50b Transfer restricting portion
111a, 111c, 112a, 116a, 116c Positive terminal
211a, 211c, 212a, 216a, 216c Negative terminal
C13 Negative voltage application closed circuit
C14 Positive voltage application closed circuit
C33 Negative voltage application closed circuit (an example of "another negative voltage application closed circuit")
C34 Positive voltage application closed circuit (an example of "another positive voltage application closed circuit")
L2a Wire (an example of "first wire")
L5a Wire (an example of "second wire")
M Load device
P1a Connection point (an example of "third connection point)
P2a Connection point (an example of "first connection point)
P3a Connection point (an example of "second connection point)
W14 Path

## Claims

1. A semiconductor switch drive circuit comprising:
a drive power source; and
a semiconductor switch drive portion electrically connected to the drive power source, and configured to drive a semiconductor switch using electric power from the drive power source,
wherein the semiconductor switch drive portion includes:
a connection switching portion electrically connected between the drive power source and the semiconductor switch, and configured to switch a connection state of the semiconductor switch;
a first capacitor electrically connected between the drive power source and the connection switching portion, and configured to generate a positive voltage for turning the semiconductor switch to an on state by being charged with the electric power from the drive power source;
a second capacitor electrically connected in parallel with the first capacitor with respect to the drive power source, and configured to be charged with the electric power from the drive power source; and
a third capacitor electrically connected between the second capacitor and the connection switching portion, and configured to generate a negative voltage for turning the semiconductor switch to an off state by being charged with electric power discharged from the second capacitor in a charged state,
wherein the connection switching portion is configured to alternately switch between
a first connection state forming a positive voltage application closed circuit configured to apply the positive voltage to a control terminal of the semiconductor switch by an electrical connection between a positive terminal of the first capacitor and the control terminal of the semiconductor switch, and
a second connection state forming a negative voltage application closed circuit configured to apply the negative voltage to the control terminal of the semiconductor switch by an electrical connection between a negative terminal of the third capacitor and the control terminal of the semiconductor switch, and
wherein a transfer restricting portion is provided between the first capacitor and the semiconductor switch, the transfer restricting portion configured to restrict transfer of electric charge of the first capacitor from a path passing through the positive voltage application closed circuit to another path passing through the positive terminal of the first capacitor and not through the control terminal of the semiconductor switch.

2. The semiconductor switch drive circuit according to claim 1, wherein the transfer restricting portion includes:
a first connection point between the positive terminal of the first capacitor and the control terminal of the semiconductor switch;
a second connection point between a positive terminal of the second capacitor and an input terminal of the semiconductor switch;
a third connection point arranged between the first connection point and a positive terminal of the drive power source, and electrically connected to the positive terminal of the drive power source;
a first wire connecting the first connection point and the third connection point; and
a second wire connecting the second connection point and the third connection point.

3. The semiconductor switch drive circuit according to claim 2, wherein the transfer restricting portion further includes:
a first diode connected with a direction from the third connection point toward the first connection point as a forward direction in the first wire; and
a second diode connected with a direction from the third connection point toward the second connection point as a forward direction in the second wire.

4. The semiconductor switch drive circuit according to claim 3, wherein the transfer restricting portion further includes:
a first resistive element connected in series with the first diode in the first wire; and
a second resistive element connected in series with the second diode in the second wire, and having a resistance value higher than a resistance value of the first resistive element.

5. The semiconductor switch drive circuit according to claim 1,
wherein the positive terminal of the first capacitor is electrically connected to a positive terminal of the drive power source and the control terminal of the semiconductor switch,
wherein a positive terminal of the second capacitor is electrically connected to the positive terminal of the drive power source,
wherein the negative terminal of the third capacitor is electrically connected to a negative terminal of the second capacitor, and
wherein a positive terminal of the third capacitor is electrically connected to the control terminal of the semiconductor switch.

6. The semiconductor switch drive circuit according to claim 1, comprising a first semiconductor switch drive portion and a second semiconductor switch drive portion being the semiconductor switch drive portion,
wherein the first semiconductor switch drive portion and the second semiconductor switch drive portion are configured to respectively drive a first semiconductor switch and a second semiconductor switch being the semiconductor switch,
wherein the first semiconductor switch forms an upper arm in the semiconductor switch drive circuit, and
wherein the second semiconductor switch forms a lower arm in the semiconductor switch drive circuit, and is electrically connected in series with the first semiconductor switch.

7. The semiconductor switch drive circuit according to claim 6,
wherein the transfer restricting portion of each of the first semiconductor switch drive portion and the second semiconductor switch drive portion includes:
a first connection point between the positive terminal of the first capacitor and the control terminal of the semiconductor switch;
a second connection point between a positive terminal of the second capacitor and an input terminal of the semiconductor switch;
a third connection point arranged between the first connection point and a positive terminal of the drive power source, and electrically connected to the positive terminal of the drive power source;
a first wire connecting the first connection point and the third connection point; and
a second wire connecting the second connection point and the third connection point, and
wherein only the transfer restricting portion of the second semiconductor switch drive portion among the first semiconductor switch drive portion and the second semiconductor switch drive portion further includes:
a first diode connected with a direction from the third connection point toward the first connection point as a forward direction in the first wire; and
a second diode connected with a direction from the third connection point toward the second connection point as a forward direction in the second wire.

8. The semiconductor switch drive circuit according to claim 1, comprising a first semiconductor switch drive portion being the semiconductor switch drive portion, and configured to drive a first semiconductor switch being the semiconductor switch, and a second semiconductor switch drive portion electrically connected to the drive power source, and configured to drive a second semiconductor switch electrically connected in series with the first semiconductor switch using the electric power from the drive power source,
wherein the first semiconductor switch forms an upper arm in the semiconductor switch drive circuit,
wherein the second semiconductor switch forms a lower arm in the semiconductor switch drive circuit,
wherein the second semiconductor switch drive portion includes:
another connection switching portion electrically connected between the drive power source and the second semiconductor switch, and configured to switch a connection state of the second semiconductor switch;
a fourth capacitor electrically connected between the drive power source and the other connection switching portion, and configured to generate a positive voltage for turning the second semiconductor switch to an on state by being charged with the electric power from the drive power source; and
a fifth capacitor electrically connected in series between the fourth capacitor and the other connection switching portion, and configured to generate a negative voltage for turning the second semiconductor switch to an off state by being charged with electric power discharged from the fourth capacitor in a charged state, and
wherein the other connection switching portion is configured to alternately switch between
a third connection state forming another positive voltage application closed circuit configured to apply the positive voltage to a control terminal of the second semiconductor switch by an electrical connection between a positive terminal of the fourth capacitor and the control terminal of the second semiconductor switch, and
a fourth connection state forming another negative voltage application closed circuit configured to apply the negative voltage to the control terminal of the second semiconductor switch by an electrical connection between a negative terminal of the fifth capacitor and the control terminal of the second semiconductor switch.

9. A power converter for converting an aspect of electric power provided by a power source into an aspect of electric power required by a load device, the power converter comprising:
the semiconductor switch electrically connected between the power source and the load device; and
the semiconductor switch drive circuit according to any one of claims 1 to 8 electrically connected to the semiconductor switch, and configured to drive the semiconductor switch.
